(19) Europäisches Patentamt / European Patent Office / Office européen des brevets

(11) **EP 1 589 566 B1**

(12) **EUROPEAN PATENT SPECIFICATION**

(45) Date of publication and mention
of the grant of the patent:
**14.01.2009 Bulletin 2009/03**

(51) Int Cl.:
*H01L 21/02* (2006.01)    *B41J 2/14* (2006.01)
*H01L 21/8246* (2006.01)    *H01L 27/115* (2006.01)
*H01L 41/22* (2006.01)

(21) Application number: **05008138.9**

(22) Date of filing: **14.04.2005**

(54) **Ferroelectric capacitor, ferroelectric memory, piezoelectric element, liquid jet head, and printer**

Ferroelektrischer Kondensator, ferroelektrischer Speicher, piezoelektrisches Element, Flüssigkeitsstrahlkopf und Drucker

Condensateur ferroélectrique, mémoire ferroélectrique, élément piezoélectrique, tête à jet de liquide et imprimante

(84) Designated Contracting States:
**DE GB NL**

(30) Priority: **23.04.2004 JP 2004128691**
**02.02.2005 JP 2005026648**

(43) Date of publication of application:
**26.10.2005 Bulletin 2005/43**

(73) Proprietor: **Seiko Epson Corporation**
**Shinjuku-ku,**
**Tokyo 163-0811 (JP)**

(72) Inventors:
• **Kijima, Takeshi**
**Suwa-shi,**
**Nagano-ken 392-8502 (JP)**

• **Hamada, Yasuaki**
**Suwa-shi,**
**Nagano-ken 392-8502 (JP)**

(74) Representative: **Hoffmann, Eckart**
**Patentanwalt,**
**Bahnhofstrasse 103**
**82166 Gräfelfing (DE)**

(56) References cited:
**EP-A- 0 495 041**    **US-A- 5 625 529**
**US-A1- 2003 036 243**    **US-B1- 6 465 260**

• **PATENT ABSTRACTS OF JAPAN vol. 1998, no. 13, 30 November 1998 (1998-11-30) -& JP 10 203868 A (SAMSUNG ELECTRON CO LTD), 4 August 1998 (1998-08-04)**

**Description**

The present invention relates to ferroelectric capacitors, and ferroelectric memories, piezoelectric elements, liquid jet heads and printers which are composed by using ferroelectric capacitors having ferroelectric capacitors.

In recent years, research and development of ferroelectric films consisting of PZT, SBT and the like, and ferroelectric capacitors, ferroelectric memory devices and the like using the same are extensively conducted. The structure of ferroelectric memory devices is roughly divided into a 1T, a 1T1C, a 2T2C, and a simple matrix type. Among them, the 1T type has a retention (data retention) that is as short as one month since an internal electric field occurs in the capacitor due to its structure, and it is said to be impossible to ensure a 10-year guarantee generally required for semiconductors. Because the 1 T1 C type and 2T2C type have substantially the same structure as that of a DRAM, and include selection transistors, such that they can take advantage of the DRAM manufacturing technology, and realize write speeds comparable to those of SRAMs, they have been manufactured so far into commercial products with a small capacity of 256-kbit or less.

Pb (Zr, Ti) $O_3$ (PZT) is mainly used so far as a ferroelectric material. In the case of these materials, compositions in a region where rhombohedral PZT and tetragonal PZT coexist with the Zr/Ti ratio being 52/48 or 40/60 or compositions in the neighborhood thereof are used, and these materials are also used doped with an element such as La, Sr, Ca or the like. This region is used to secure reliability, which is most essential for memory devices. Although a Ti rich tetragonal region originally has a good hysteresis shape, Schottky defects that originate in the ionic crystal structure occur, and as a result, defects in leakage current characteristics or imprint characteristics (so-called degree of deformation of hysteresis) are generated, and thus it is difficult to secure the reliability.

A simple matrix type of ferroelectric memory has a smaller cell size compared to the 1T1C type and 2T2C type and allows multilayering of capacitors, such that a higher integration and a cost reduction may be expected.

It is noted that conventional simple matrix type ferroelectric memory devices are described in JP 9-116107 A. This document describes a drive method in which a voltage that is one-third a write voltage is applied to non-selected memory cells when writing data into the selected memory cells.

However, this prior art does not provide any description concerning the hysteresis loops of ferroelectric capacitors which are necessary for operations. A hysteresis loop having good squareness is indispensable to obtain a simple matrix type ferroelectric memory device that can be practically operated. As a ferroelectric material that can meet such requirements, Ti rich tetragonal PZT can be considered as a candidate, and the most important task is to secure its reliability to be like that of the aforementioned 1 T1 C type and 2T2C type ferroelectric memory devices.

Furthermore, although a tetragonal PZT exhibits a hysteresis characteristic having a squareness that is suitable for memory usage, its reliability is poor and it has not been put to practical use, because of the following reasons.

First, a PZT tetragonal thin film after crystallization has a tendency that the higher the Ti proportion, the higher the density of leakage current rises. In addition, when a so-called static imprint test is conducted, in which data is written once in a memory in either a positive (+) direction or a negative (-) direction, the memory is retained at 100 °C, and the data is then read, the written data are scarcely held for 24 hours. This is an inherent problem of PZT that is an ionic crystal and Pb and Ti that are constituent elements of the PZT, and this poses the most difficult problem of a PZT tetragonal thin film in which the majority of its constituent elements consists of Pb and Ti. This problem is largely attributable to the fact that the PZT perovskite is an ionic crystal, which is an inherent problem of PZT.

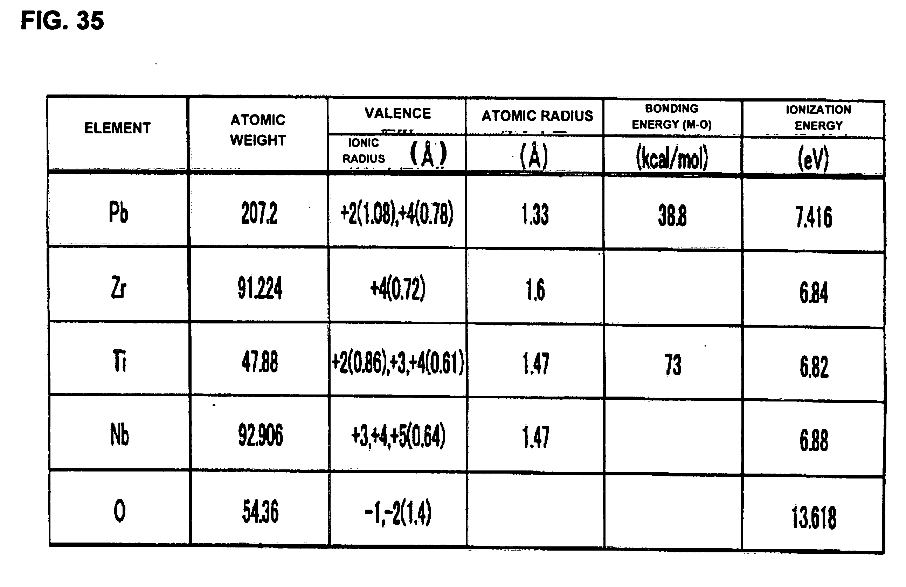

FIG. 35 is a table showing main energies involved in the bonds of constituent elements of PZT. It is known that PZT after crystallization includes many oxygen vacancies. In other words, it is predicted from FIG. 35 that Pb-O bonds have the smallest bond energy among the PZT constituent elements, and may readily break at the time of sintering and heating and at the time of polarization inversions. In other words, O escapes due to the principle of charge neutralization when Pb escapes.

The constituent elements of PZT vibrate and repeatedly collide with one another during sustained heating such as at the time of imprint testing or the like. Because Ti is the lightest element among the PZT constituent elements, it would easily come off by these vibrational collisions during high-temperature retention. Therefore, O escapes due to the principle of charge neutralization when Ti escapes. Since the maximum valence of +2 for Pb and +4 for Ti contribute to bonding, there is no way to maintain charge neutrality other than allowing O to escape. In other words, two negative O ions escape readily for each positive ion of Pb or Ti, such that the so-called Schottky defects easily occur.

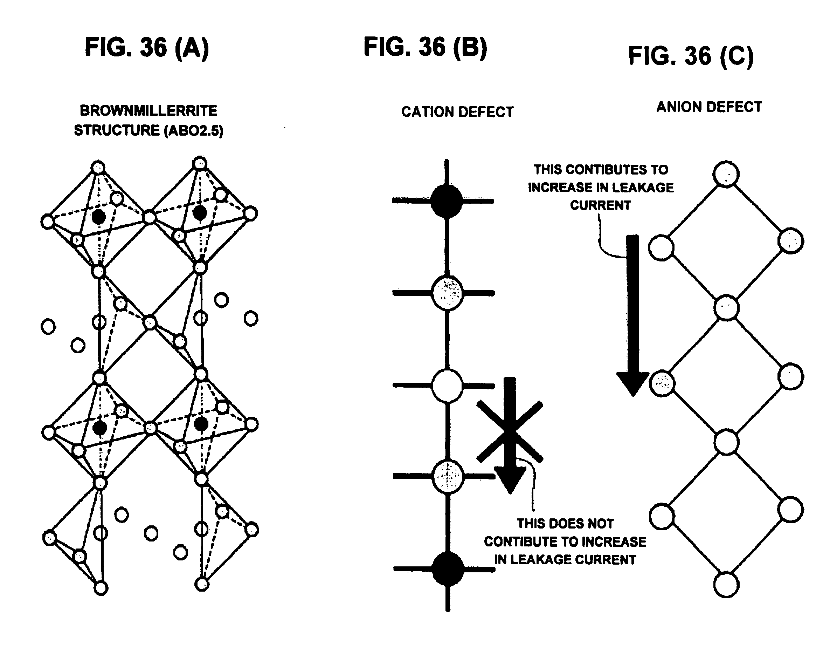

Descriptions are now made as to the mechanism of the generation of leakage currents due to oxygen vacancies in PZT crystals. FIGS. 36 (A) to 36 (C) are views for describing the generation of leakage currents in oxide crystals having a Brownmillerite type crystal structure expressed by the general formula of $ABO_{2.5}$. As shown in FIG. 36 (A), the Brownmillerite type crystal structure is a crystal structure having an oxygen vacancies, as compared to a perovskite type crystal structure of PZT crystals expressed by the general formula of $ABO_3$. As shown in FIG. 36 (B), because oxygen ions appear adjacent to positive ions in the Brownmillerite type crystal structure, positive ion defects would be difficult to cause leakage current to increase. However, as shown in FIG. 36 (C), oxygen ions link the entire PZT crystal in series, and when the crystal structure becomes a Brownmillerite type crystal structure as the oxygen vacancies increase, leakage currents increase accordingly.

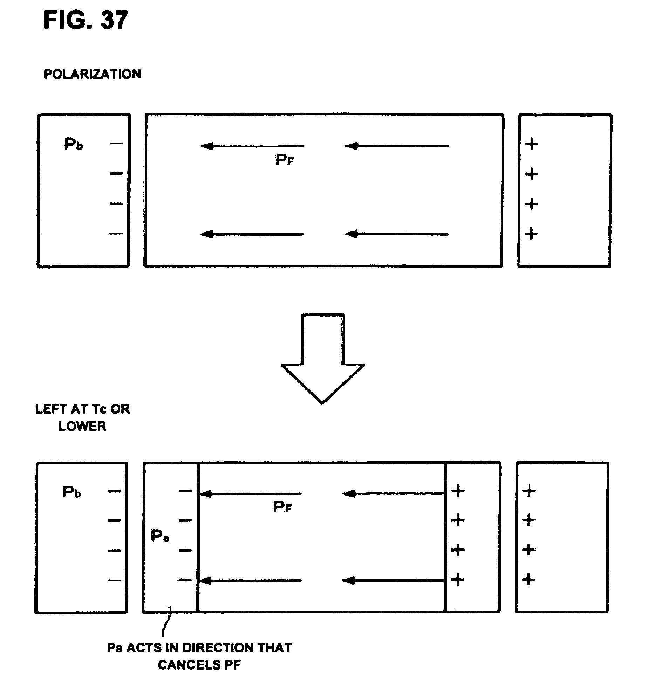

In addition to the generation of leakage currents described above, vacancies of Pb and Ti and the accompanying vacancies of $O_1$ which are so-called lattice defects, cause a spatial charge polarization shown in FIG. 37. When that happens, reverse electrical fields due to lattice defects that are created by the electrical fields of ferroelectric polarization can occur, causing a state in which the bias potential is impressed to the PZT crystals, and, as a result, a hysteresis shift or depolarization can occur. Moreover, these phenomena are likely to occur quicker as the temperature increases.

The problems described above are inherent to PZT and it is considered difficult to solve these problems in pure PZT. Therefore, memory elements made by using tetragonal PZT having adequate characteristics have not been achieved so far.

It is an object of the present invention to provide ferroelectric capacitors having excellent characteristics with few crystal defects.

It is another object of the present invention to provide 1T1C, 2T2C, and simple matrix type ferroelectric memories, which include a ferroelectric capacitor having hysteresis characteristics usable to any of the 1T1C, 2T2C, and simple matrix type ferroelectric memories.

It is still another object of the present invention to provide piezoelectric elements, liquid jet heads, and printers, which use these ferroelectric capacitors.

These objects are achieved by a ferroelectric capacitor as claimed in claim 1 and its use in piezoelectric elements, liquid jet heads, and printers.

Also, the present invention is applicable to ferroelectric memories and piezoelectric elements using the ferroelectric capacitor described above.

A ferroelectric memory in accordance with the present invention includes a first electrode that conducts with a source or drain electrode of a CMOS transistor formed in advance on a Si wafer, a ferroelectric film formed on the first electrode, and a second electrode formed on the ferroelectric film, wherein a capacitor formed from the first electrode, the ferroelectric film and the second electrode is a ferroelectric memory that is selectively operated by the CMOS transistor formed in advance on the Si wafer, and the ferroelectric film may be formed from a ferroelectric film that consists of tetragonal PZT with a Ti ratio being 50% or more, wherein Nb replaces the Ti composition by 5 mol% or more but 40 mol% or less, and at the same time includes Si and Ge by 1 mol% or more.

Also, a ferroelectric memory in accordance with the present invention includes a first electrode fabricated in advance, a second electrode arranged in a direction intersecting the first electrode, and a ferroelectric film disposed at least in an intersection area between the first electrode and the second electrode, wherein a capacitor formed from the first electrode, the ferroelectric film and the second electrode is a ferroelectric memory that is disposed in a matrix configuration, and the ferroelectric film may be formed from a ferroelectric film that consists of tetragonal PZT with a Ti ratio being 50% or more, wherein Nb replaces the Ti composition by 5 mol% or more but 40 mol% or less, and at the same time includes Si and Ge by 1 mol% or more.

Preferred embodiments of the present invention are described below with reference to the accompanying drawings.

FIG. 1　　is a cross-sectional view schematically showing a ferroelectric capacitor in accordance with an embodiment;

FIG. 2　　shows a flow chart illustrating steps for forming a PZTN film by a spin coat method in accordance with an embodiment;

FIG. 3　　is a view showing a P (polarization) - V (voltage) hysteresis curve of a ferroelectric capacitor in accordance with an embodiment.

FIG. 4　　shows surface morphologies of PZTN films in accordance with Example 1 of the present embodiment;

FIG. 5　　shows crystallinity of PZTN films in accordance with Example 1 of the present embodiment;

FIG. 6　　shows the relationship between film thickness and surface morphology of PZTN films in accordance with Example 1 of the present embodiment;

FIG. 7　　shows the relationship between film thickness and crystallinity of PZTN films in accordance with Example 1 of the present embodiment;

FIG. 8　　shows the relationship between film thickness and hysteresis characteristics of PZTN films in accordance with Example 1 of the present embodiment;

FIG. 9      shows the relationship between film thickness and hysteresis characteristics of PZTN films in accordance with Example 1 of the present embodiment;

FIG. 10      shows the leakage current characteristics of PZTN films in accordance with Example 1 of the present embodiment;

FIG. 11      shows the fatigue characteristic and the static imprint characteristic of a PZTN film in accordance with Example 1 of the present embodiment;

FIG. 12      shows the configuration of a capacitor in accordance with Example 1 of the present embodiment in which an $SiO_2$ protection film is formed by ozone TEOS;

FIG. 13      shows the hysteresis characteristic of the capacitor in accordance with Example 1 of the present embodiment after the $SiO_2$ protection film has been formed by ozone TEOS;

FIG. 14      show the leakage current characteristics of conventional PZT films considered in Example 1 of the present embodiment;

FIG. 15      shows the fatigue characteristics of conventional PZT capacitors considered in Example 1 of the present embodiment;

FIG. 16      shows the static imprint characteristics of conventional PZT capacitors considered in Example 1 of the present embodiment;

FIG. 17      shows the hysteresis characteristics of PZTN films in accordance with Example 2 of the present embodiment;

FIG. 18      shows the hysteresis characteristics of PZTN films in accordance with Example 2 of the present embodiment;

FIG. 19      shows the hysteresis characteristics of PZTN films in accordance with Example 2 of the present embodiment;

FIG. 20      shows X-ray diffraction patterns of PZTN films in accordance with Example 2 of the present embodiment;

FIG. 21      shows the relationship between Pb vacancies and Nb composition ratios in a PZTN crystal in accordance with Example 2 of the present embodiment;

FIG. 22      shows a diagram for describing the $WO_3$ crystal structure that is a perovskite crystal;

FIG. 23      schematically shows a process of forming a PZTN film in accordance with Example 3 of the present embodiment;

FIG. 24      shows figures for describing changes in lattice constant in a PZTN film in accordance with Example 3 of the present embodiment;

FIG. 25      shows a graph for describing changes in lattice mismatch ratio between PZTN films and Pt metal films in accordance with Example 3 of the present embodiment;

FIG. 26      shows a flowchart of a method for forming a conventional PZT film by a spin coat method, as a reference example considered in the present embodiment;

FIG. 27      shows the surface morphologies of PZT films, as reference examples of the present embodiment;

FIG. 28      shows the crystallinity of PZT films, as reference examples of the present embodiment;

FIG. 29      shows the hysteresis loops of tetragonal PZT films, as reference examples of the present embodiment;

FIG. 30            shows the hysteresis loops of conventional tetragonal PZT films, as reference examples considered in the present embodiment;

FIG. 31            shows the results of degassing analysis conducted on tetragonal PZT films, as reference examples of the present embodiment;

FIG. 32            shows a plan view and a cross-sectional view schematically illustrating a simple matrix type ferroelectric memory device in accordance with an embodiment;

FIG. 33            shows a cross-sectional view illustrating an example of a ferroelectric memory device in accordance with an embodiment in which a memory cell array is integrated with a peripheral circuit on the same substrate;

FIG. 34            shows a cross-sectional view and a circuit diagram schematically illustrating a 1T1C type ferroelectric capacitor in accordance with a modified example of the present embodiment;

FIG. 35            is a table showing various characteristics concerning the bonds of constituent elements of PZT ferroelectric;

FIG. 36            shows diagrams for describing Schottky defects of the Brownmillerite type crystal structure;

FIG. 37            shows diagrams for describing a spatial charge polarization of ferroelectric;

FIG. 38            shows an exploded perspective view of a recording head in accordance with an embodiment;

FIG. 39            shows a plan view and a cross-sectional view of a recording head in accordance with an embodiment;

FIG. 40            schematically shows a layered structure of a piezoelectric element in accordance with an embodiment;

FIG. 41            schematically shows one example of an ink-jet recording apparatus in accordance with an embodiment;

FIG. 42            shows the hysteresis characteristics of ferroelectric layers in which Ta or W is added in PZT in accordance with the present embodiment;

FIG. 43            shows a sample used in accordance with Example 4 of the present embodiment;

FIG. 44(A) and (B)   show the results of RBS and NRA analysis obtained in Example 4;

FIG. 45(A)         and (B) show the results of AES analysis obtained in Example 4;

FIG. 46            illustrate a method to obtain a diffusion length of oxygen atoms according to the results of RBS and NRA analysis in Example 4;

FIG. 47            illustrate a method to obtain a diffusion length of oxygen atoms according to the results of AES analysis in Example 4;

FIG. 48A           shows a Raman spectrum of a PZTN (36/44/20) film in accordance with Example 5 of the present embodiment;

FIG. 48B           shows a Raman spectrum of a tetragonal PZTN (20/60/20) film, as a reference example;

FIG. 49A           shows a cross-sectional profile of the PZTN (36/44/20) film in accordance with Example 5 of the present embodiment;

FIG. 49B              shows a cross-sectional profile of the PZT (56/44) film for comparison considered in Example 5 of the present embodiment;

FIG. 50A              shows results of compositional analysis in the depth direction by ESCA conducted on the PZTN (36/44/20) film in accordance with Example 5 of the present embodiment;

FIG. 50B              shows results of compositional analysis in the depth direction by ESCA conducted on the PZT (56/44) film for comparison;

FIG. 51               shows a graph that compares piezoelectric characteristics ($d_{33}$) of the PZTN (36/44/20) film in accordance with Example 5 of the present embodiment and the PZT (56/44) film for comparison;

FIG. 52A              shows a graph indicating orientations of the PZTN (36/44/20) film in accordance with Example 5 of the present embodiment formed on a 6-inch wafer in a central area thereof;

FIG. 52B              shows a graph indicating orientations of the PZTN (36/44/20) film in accordance with Example 5 of the present embodiment formed on a 6-inch wafer in a peripheral area thereof.

## 1. Ferroelectric Capacitor and Method of Manufacturing the Same

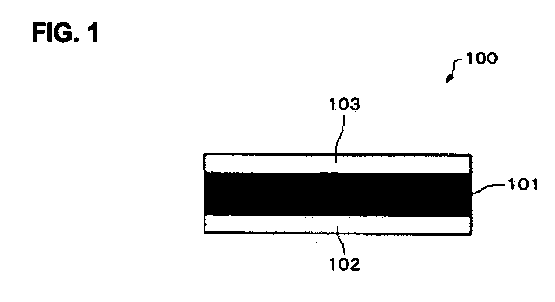

FIG. 1 is a cross-sectional view schematically showing a ferroelectric capacitor 100 that uses a ferroelectric capacitor in accordance with an embodiment of the present invention.

As shown in FIG. 1, the ferroelectric capacitor 100 is formed from a ferroelectric film 101, a first electrode 102 and a second electrode 103.

The first electrode 102 and the second electrode 103 are formed from a single platinum group element such as Pt, Ir, Ru, or the like, or a composite material mainly composed of a platinum group element. If elements of the ferroelectric diffuse into the first electrode 102 and the second electrode 103, composition shifts occur at the interfaces between the electrodes and the ferroelectric film 101, and the squareness of its hysteresis deteriorates. Accordingly, the first electrode 102 and the second electrode 103 require a density which does not allow diffusion of the elements of the ferroelectric. In order to increase the density of the first electrode 102 and the second electrode 103, for example, a method of forming a film by sputtering using a gas with a large mass, or a method of dispersing an oxide of Y, La, or the like into an electrode of a platinum group element may be employed. In the present invention, almost no diffusion of oxygen from the ferroelectric film into the electrode is recognized, as described below.

The ferroelectric film 101 is formed by using a PZT-system ferroelectric composed of oxides including Pb, Zr and Ti as constituent elements. In particular, the present embodiment is characterized in that the ferroelectric film 101 uses Pb (Zr, Ti, Nb) $O_3$ (PZTN) in which Nb is doped in the Ti site.

In other words, the ferroelectric of the PZT system ferroelectric film described above is expressed by the general formula of $PbZr_xTi_yNb_z$, and the following relations establish:

$$x + y + z = 1$$

and

$$0 \leq x \leq 0.975$$

Concretely, 2.5 mol % or more but 40 mol % or less, more preferably, 5 mol % or more but 30 mol % or less, and even more preferably, 10 mol % or more but 30 mol % or less of the Ti proportion of the ferroelectric film 101 can be replaced with Nb.

In addition, the electrodes 102 and 103 are characterized in that they scarcely include oxygen that diffuses from the ferroelectric film 101. This is affirmed by the following analysis methods. More specifically, the diffusion length of oxygen in the electrodes from the ferroelectric film can be 15 nm or less, as obtained from a profile according to a Rutherford backscattering analysis method (RBS) and a nuclear reaction analysis method (NRA). Also, the diffusion length of oxygen in the electrodes from the ferroelectric film can be 30 nm or less, as obtained from a profile according to an Auger electron spectroscopy (AES). Methods to obtain the diffusion length using these analysis methods are explained in detail below.

RBS and NRA are methods in which a high energy ion beam of several MeV is irradiated to sample atoms, and particles that come out by scattering or reaction are detected, whereby the distribution of elements of each kind in the depth direction is analyzed. Since there are elements that are well detected and elements that are not well detected for each of the methods, both of the methods are used together.

AES is a method in which an electron beam of several keV is irradiated to sample atoms, and electrons that are discharged are analyzed, whereby the proportion of elements of each kind adjacent to the sample surface is analyzed. Since AES can analyze only an area adjacent to the sample surface, the analysis is conducted while cutting the sample surface when the distribution of elements at each different depth is to be analyzed.

Neither RBS nor NRA is a commonly practiced method because they use a high energy ion beam, but they are analysis methods with high accuracy in the direction of depth because information on depth is contained in the detected particles. On the other hand, in AES, detected electrons do not contain information on depth, such that accuracy in the direction of depth is not as high as that of the former methods. But this is one of analysis methods that are commonly used, and is an analysis method with higher accuracy in the direction of depth among them.

As described above, the ferroelectric capacitor of the present embodiment has a ferroelectric film that is formed from PZTN, and even in a high temperature condition at 725 °C, the diffusion of oxygen atoms of the ferroelectric film into the electrodes stops at the depth of several tens nm or less, as described later, which can be an extremely small diffusion length compared to PZT. Thus, because the diffusion of oxygen into the electrodes is extremely little, and it can be said that such oxygen diffusion hardly exists compared to the conventional PZT, the squareness of hysteresis would not be deteriorated as a result of a compositional difference occurring at the interface section between the electrodes and the ferroelectric film.

In addition or as an alternative, the ferroelectric capacitor in accordance with the present embodiment is characterized in that the ferroelectric film has a generally constant distribution of proportion of oxygen atoms in the ferroelectric film.

Concretely, the distribution of proportion of oxygen atoms in the ferroelectric film may be 1 % or less, when a difference in proportion of oxygen atoms in the ferroelectric film in the direction of film thickness thereof is expressed by (a maximum value - a minimum value) / (an average value of the maximum value and the minimum value) and obtained from a profile according to RBS and NRA. Also, it may be 3% or less, when a similar difference is obtained from a profile according to AES. Concrete methods to obtain the difference in proportion of oxygen atoms are explained in detail below.

The fact that the ferroelectric film has a little difference in proportion of oxygen atoms in the present embodiment means that almost all of the oxygen atoms are at lattice positions in the ferroelectric where they should originally be, and that breakage of the crystal lattice that originates in vacancies of oxygen atoms is hardly present. In other words, it can be said that 95% or more of oxygen included in the ferroelectric film can exist at the oxygen positions of the perovskite structure. This means that, not only oxygen that would most likely migrate, but also other elements such as Pb, Zr and Ti would be difficult to diffuse, and the film of PZTN itself has a barrier property, for example, a high oxygen barrier property.

In the ferroelectric capacitor in accordance with the present embodiment, the ferroelectric film may contain a Ti proportion higher than the Zr proportion. More specifically, the proportion of Ti can be 50% or greater. Also, the ferroelectric film may have a crystal structure of at least one of tetragonal and rhombohedral systems.

In the present invention, it is believed that PZTN has the characteristics described above because of the following reasons. Because Nb has generally the same size as that of Ti (the ionic radii are close to each other and the atomic radii are the same) and weighs two times, it is hard for atoms to escape the lattice even by collision among atoms by lattice vibration. Also, the valence of Nb is stable at +5, so that even if the Pb escapes, the atomic weight after the Pb has escaped can be compensated for by the $Nb^{5+}$. Furthermore, during the crystallization, even if Pb escape occurs, it is easier for the small-sized Nb to enter than the large-sized O to escape.

Since there are also some Nb atoms with a valence of +4, it is possible that the substitution of $Ti^{4+}$ is performed sufficiently. In addition, it is believed that the covalence of Nb is extremely strong in practice, making it difficult for Pb to escape (see H. Miyazawa, E. Natori, S. Miyashita; Jpn. J. Appl. Phys. 39 (2000) 5679).

Until now, the Nb doping in PZT has been mainly performed into Zr-rich rhombohedral crystal regions and is extremely small, on the order of 0.2 to 0.025 mol % (see J. Am. Ceram. Soc, 84 (2001) 902 and Phys. Rev. Let, 83 (1999) 1347). The main reason why it has not been possible to dope a large amount of Nb is considered to be because the addition of 10 mol % of Nb, for example, would increase the crystallization temperature to at least 800°C.

In this case, $PbSiO_3$ silicate may preferably be further added at a rate of 1 to 5 mol %, for example, during the formation of the ferroelectric film 101. This makes it possible to reduce the crystallization energy of the PZTN. In other words, if PZTN is used as the material of the ferroelectric film 101, the addition of $PbSiO_3$ silicate makes it possible to design a reduction in the crystallization temperature of the PZTN.

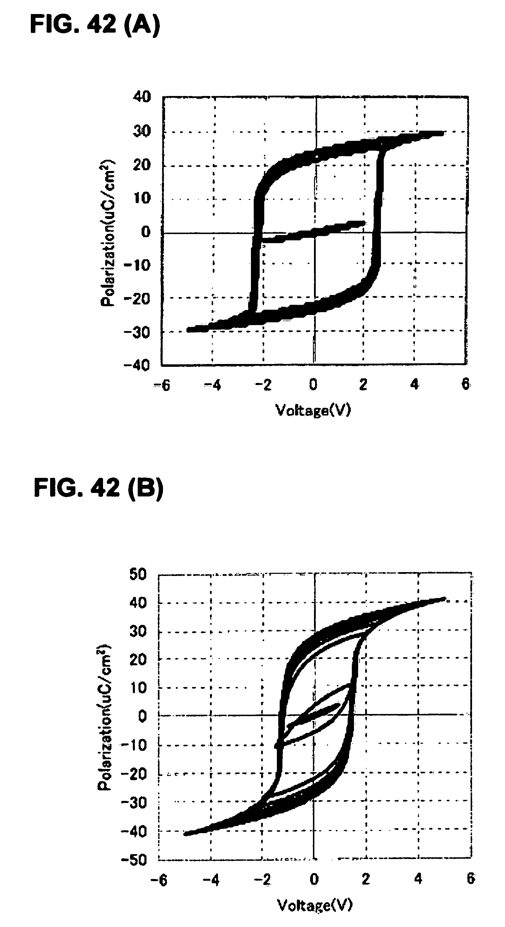

Also, in the present embodiment, the ferroelectric film 101 has equivalent effects when Ta, W, V, or Mo is added to PZT as an additive substance instead of Nb. Moreover, when Mn is used as an additive substance, effects similar to those provided by Nb are achieved. Further, in a similar idea, Pb may be replaced with an element with a valence of +3 or greater to prevent Pb from escaping. A lanthanoid system element, such as, La, Ce, Pr, Nd, Pm, Sm, Eu, Gd, Tb, Dy, Ho, Er, Tm, Yb, and Lu may be enumerated as a representative element. In addition, a germanate (Ge) may be used instead of a silicate (Si) as an additive to promote the crystallization. FIG. 42 (A) shows hysteresis characteristics when 10 mol % of Ta is used for PZT as an additive substance instead of Nb. Also, FIG. 42 (B) shows hysteresis characteristics when 10 mol % of W is used for PZT as an additive substance instead of Nb. It is observed that effects equal to those provided by addition of Nb are achieved when Ta is used. Moreover, it is also observed that effects equal to those provided by addition of Nb are achieved when W is used, in view of the fact that hysteresis characteristics with an excellent insulation property are obtained.

Next, an example of a film forming method to form the PZTN ferroelectric film 101 that is applied to the ferroelectric capacitor 100 in accordance with an embodiment is described.

The PZTN ferroelectric film 101 can be obtained by preparing a mixed solution of a first, a second and a third raw material liquid including at least one of Pb, Zr, Ti and Nb, and crystallizing oxides contained in the mixed solution by heat treatment or the like.

The first raw material liquid may be, for example, a solution in which a condensation polymer for forming a $PbZrO_3$ perovskite crystal structure with Pb and Zr among the constituent metal elements of the PZTN ferroelectric phase is dissolved in a solvent such as n-buthanol in an anhydrous state.

The second raw material liquid may be, for example, a solution in which a condensation polymer for forming a $PbTiO_3$ perovskite crystal structure with Pb and Ti among the constituent metal elements of the PZTN ferroelectric phase is dissolved in a solvent such as n-buthanol in an anhydrous state.

The third raw material liquid may be, for example, a solution in which a condensation polymer for forming a $PbNbO_3$ perovskite crystal structure with Pb and Nb among the constituent metal elements of the PZTN ferroelectric phase is dissolved in a solvent such as n-buthanol in an anhydrous state.

For example, when the ferroelectric film 101 composed of $PbZr_{0.2}Ti_{0.6}Nb_{0.2}O_3$ (PZTN) is to be obtained by using the first, second and third raw material liquids, they are mixed in a mixing ratio ((the first raw material liquid) : (the second raw material liquid) : (the third raw material liquid)) of 2 : 6 : 2. However, a high crystallization temperature would be required to form the PZTN ferroelectric film 101 if the mixed solution is crystallized as it is. More specifically, the addition of Nb abruptly increases the crystallization temperature, making crystallization impossible in the temperature range that enables creation of devices, namely below 700°C. Therefore, conventionally, Nb in the amount of 5 mol% or greater has not been used as a replacement element for Ti, and Nb is limited to the use only as an additive. In addition, there have been no cases of a PZT tetragonal crystal system in which Ti is contained in an amount greater than Zr. This is obvious from reference documents, such as, J. Am, Ceram. Soc, 84 (2001) 902 and Phys. Rev. Let, 83 (1999) 1347.

According to the present embodiment, the above-described problem can be solved by further adding to the above-described mixed solution a solution, as a fourth raw material liquid, in which 1 mol% or greater but less than 5 mol% of a condensation polymer for forming a $PbSiO_3$ crystal structure is dissolved in a solvent such as n-buthanol in an anhydrous state.

In other words, by using the mixed solution of the first, second, third and fourth liquids, the crystallization temperature of PZTN can be lowered, and the PZTN can be crystallized in a device creatable temperature range of 700 °C or below.

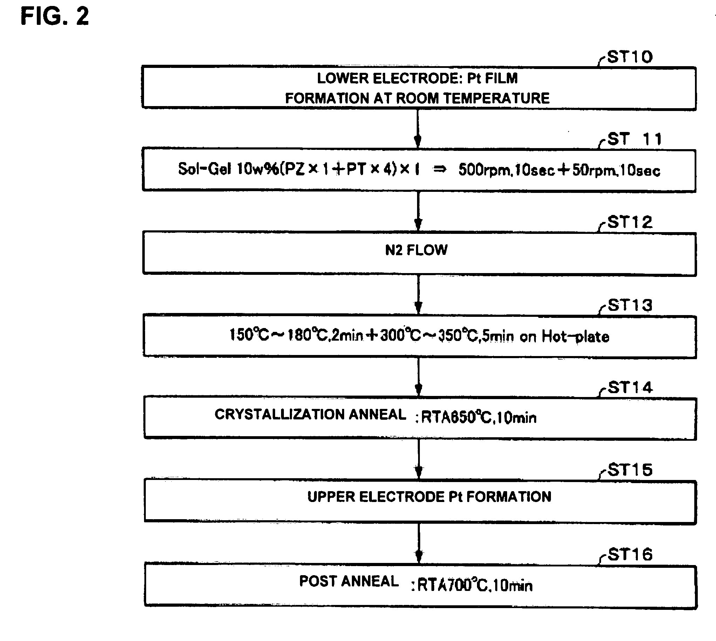

More specifically, the ferroelectric film 101 is formed according to a flow chart shown in FIG. 2. A series of steps consisting of a mixed solution coating step (step ST11), an alcohol removal step, a dry thermal treatment step, and a cleaning thermal treatment step (step ST12, step ST13) is conducted a desired number of times, and then a sintering step (step ST14) is conducted for crystallization annealing to form the ferroelectric film 101.

Examples of the conditions in each of the steps are given below.

First, a lower electrode is formed by coating a precious metal for electrodes such as Pt or the like on an Si substrate (step ST10). Then, the mixed liquid is coated by a coating method such as spin coating (step ST11). More specifically, the mixed solution is dripped onto the Pt coated substrate. In order to spread the dripped mixed solution over the entire substrate surface, the substrate is rotated at about 500 rpm, then the rotation speed is reduced to 50 rpm or below and rotation is continued for about 10 seconds. The dry thermal treatment step is conducted at 150 °C - 180 °C (step ST13). The dry thermal treatment step is conducted by using a hot-plate or the like in the air atmosphere. Similarly, the cleaning thermal treatment step is conducted in the air atmosphere using a hot-plate, which is held at 300 °C - 350 °C (step ST13). The sintering step for crystallization is conducted by using rapid thermal annealing (RTA) or the like in an oxygen atmosphere (step ST14).

It is noted that the film thickness after sintering can be about 100 - 200 nm. Next, an upper electrode is formed by sputtering or the like (step ST15), and then post-annealing is conducted for the purpose of forming an interface between the upper electrode and the ferroelectric thin film and improving the crystallinity of the ferroelectric thin film, using RTA or the like in an oxygen atmosphere in a manner similar to the sintering step (step ST16), thereby obtaining the ferroelectric capacitor 100.

Influences caused by the use of the PZTN ferroelectric film 101 on the hysteresis characteristics of the ferroelectric capacitor 100 are considered below.

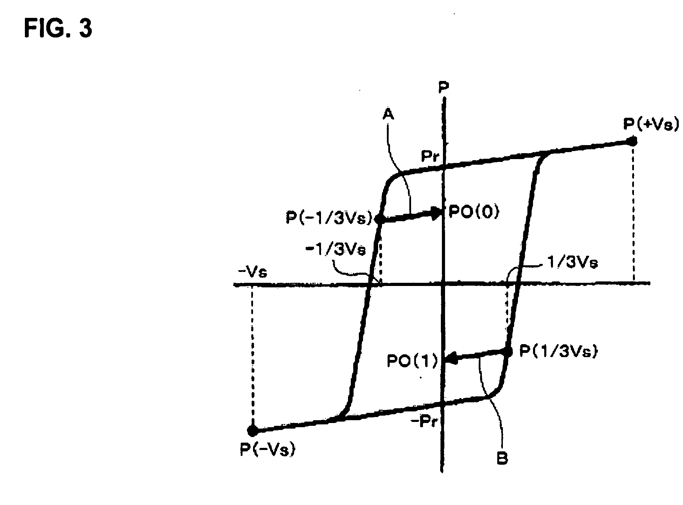

FIG. 3 is a view schematically showing a P (polarization) - V (voltage) hysteresis curve of the ferroelectric capacitor 100. First, the polarization becomes P(+Vs) upon application of a voltage of +Vs, and then the polarization becomes Pr upon application of a voltage of 0. Further, the polarization becomes P(-1/3 Vs) upon application of a voltage of -1/3 Vs. Then, the polarization becomes P(-Vs) upon application of a voltage of -Vs, and the polarization becomes -Pr when the voltage is returned to 0. The polarization becomes P(+1/3 Vs) upon application of a voltage of +1/3 Vs, and the polarization returns again to P(+Vs) when the voltage is returned to +Vs.

Also, the ferroelectric capacitor 100 has the following features with respect to its hysteresis characteristics. First, after applying a voltage of Vs to cause the polarization P(+Vs), a voltage of -1/3 Vs is applied and the applied voltage is then changed to 0. In this case, the hysteresis loop follows a locus indicated by an arrow A shown in FIG. 3, and the polarization has a stable value of P0(0). Also, after applying a voltage of -Vs to cause the polarization P(-Vs), a voltage of +1/3 Vs is applied and the applied voltage is then changed to 0. In this case, the hysteresis loop follows a locus indicated by an arrow B shown in FIG. 3 and the polarization has a stable value of P0(1). If the difference between the polarization P0(0) and the polarization P0(1) is sufficiently secured, a simple matrix type ferroelectric memory device can be operated by using the drive method disclosed in JP 9-116107 A.

With the ferroelectric capacitor 100 in accordance with the present embodiment, a decrease in crystallization temperature, an increase in squareness of the hysteresis, and an increase in Pr can be achieved. An increase in squareness of the hysteresis of the ferroelectric capacitor 100 has significant effects on its stability against disturbance, which is important for driving the simple matrix type ferroelectric memory device. In the simple matrix type ferroelectric memory device, since a voltage of $\pm 1/3$ Vs is applied to the cells in which neither writing nor reading is performed, the polarization must not be changed at this voltage, in other words, disturbance characteristics need to be stable. The present inventors have actually confirmed that, although the polarization of ordinary PZT is decreased by about 80% when a 1/3 Vs pulse is applied $10^8$ times in the direction in which the polarization is reversed from a stable state, the amount of decrease is 10% or less according to ferroelectric capacitor 100 in accordance with the present embodiment. Accordingly, by applying the ferroelectric capacitor 100 of the present embodiment to a ferroelectric memory device, a simple matrix type memory can be put to practical use.

Examples concerning the present embodiment are described in detail below.

(1) Example 1

In the present example, PZTN in accordance with the present invention and conventional PZT are compared. The film forming was conducted according to the process flow shown in FIG. 2 described above.

The ratio of Pb : Zr : Ti : Nb was set to 1 : 0.2 : 0.6 : 0.2. 0 mol%, 0.5 mol% and 1 mol%, respectively, $PbSiO_3$ was added.

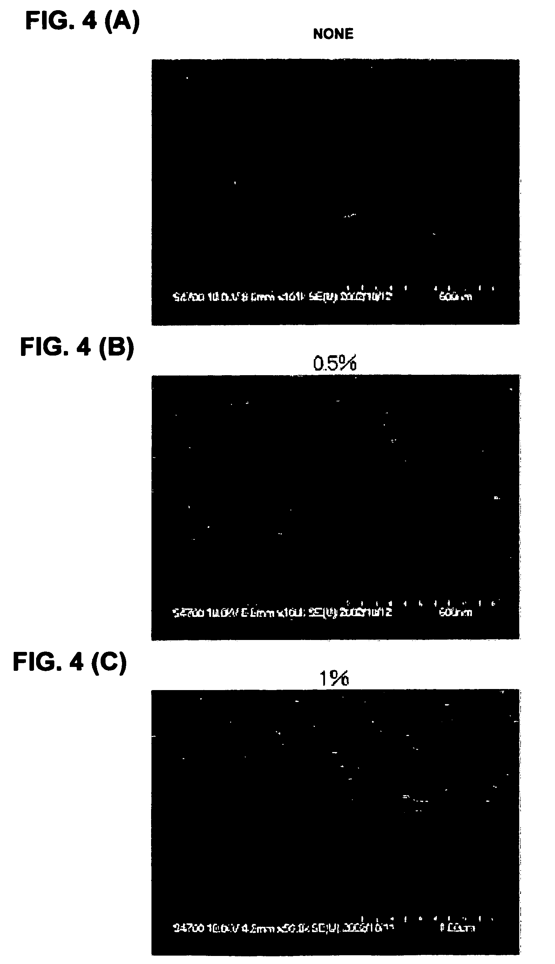

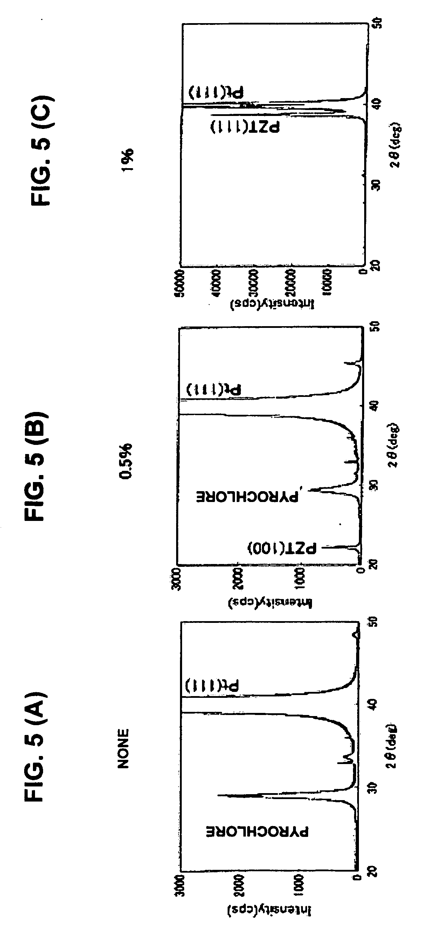

Surface morphologies of the films obtained are shown in FIGS. 4 (A) - 4 (C). Also, the crystallinity of the films was measured by an X-ray diffraction method, and the results shown in FIGS. 5 (A) - 5 (C) were obtained. In the case of 0% (none) $PbSiO_3$ shown in FIG. 5 (A), paraelectric pyrochlore alone was obtained even when the crystallization temperature was raised to 800°C. In the case of 0.5 mol% $PbSiO_3$ shown in FIG. 5 (B), PZT and pyrochlore were present in a mixed state. Also, in the case of 1 mol% $PbSiO_3$ shown in FIG. 5 (C), a single oriented film of PZT (111) was obtained, and its crystallinity was excellent to a level that had never been achieved before.

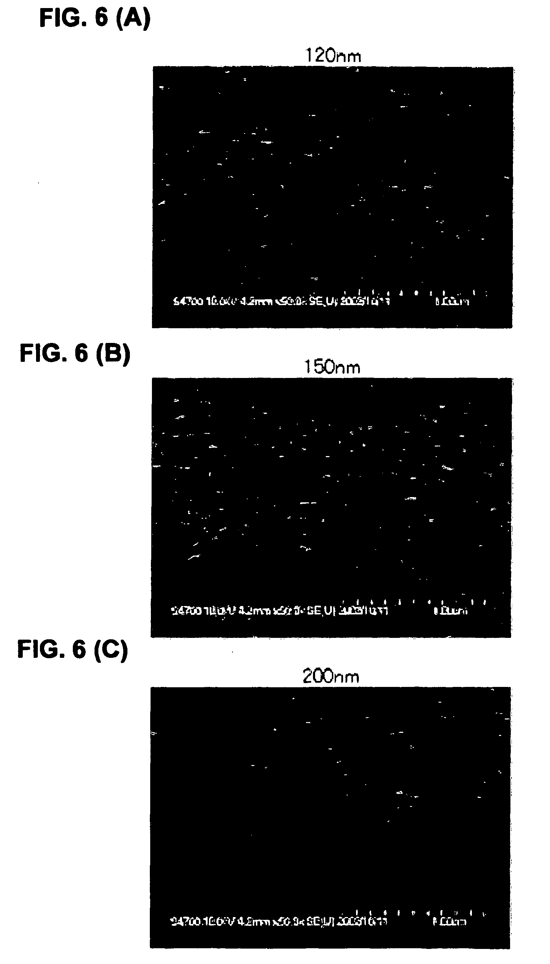

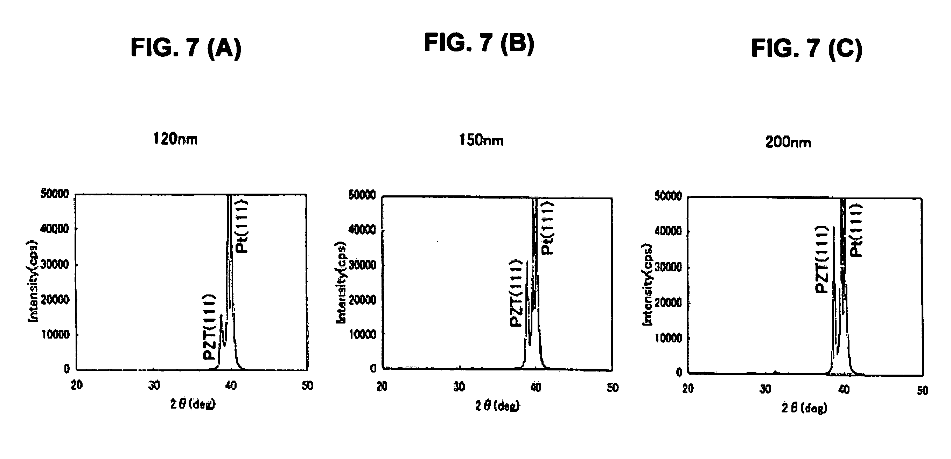

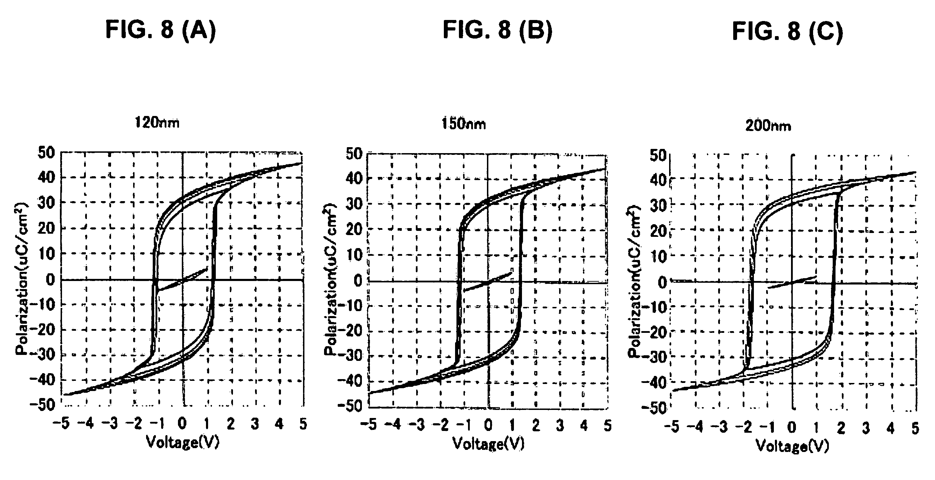

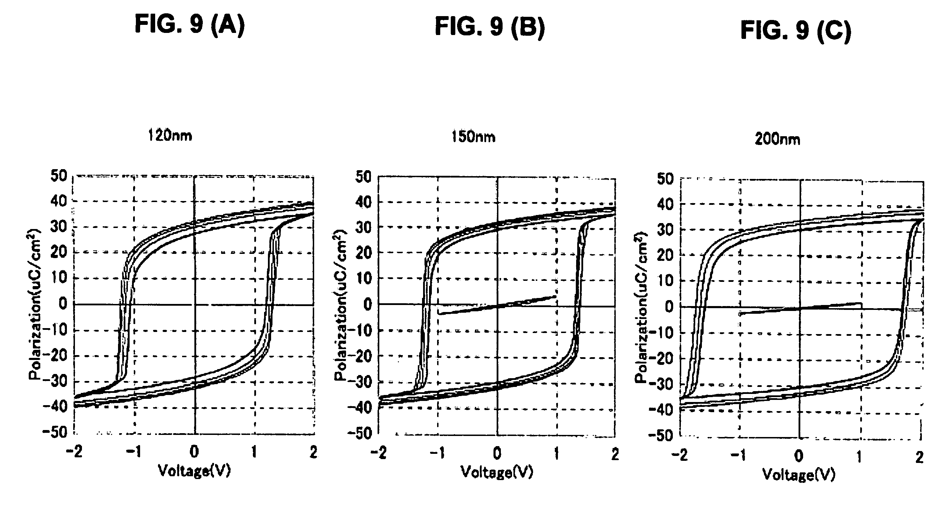

Next, PZTN thin films in which 1 mol% $PbSiO_3$ was added were formed in different film thickness ranging from 120 nm to 200 nm. FIGS. 6 (A) - 6 (C) and FIGS. 7 (A) - 7 (C) show that the levels of crystallinity that were obtained are proportional to the respective film thickness. It is noted that FIGS. 6 (A) - 6 (C) are electron micrographs showing the surface morphologies for the film thickness ranging from 120 nm to 200 nm, and FIGS. 7 (A) - 7 (C) show the results of measurements conducted by an X-ray diffraction method showing the crystallinity of PZTN thin films of film thicknesses ranging from 120 nm to 200 nm. As shown in FIGS. 8 (A) - 8 (C) and FIGS. 9 (A) - 9 (C), hysteresis characteristics with good squareness were obtained over the entire range of film thickness from 120 nm to 200 nm. It is noted that FIGS. 9 (A) - 9 (C) are enlarged views of the hysteresis curves of FIGS. 8 (A) - 8 (C). In particular, as shown in FIGS. 9 (A) - 9 (C), it was confirmed that, in the ZPTN thin films of the present examples, the hysteresis curves clearly opened up and also reached saturation at low voltages at 2 V or less.

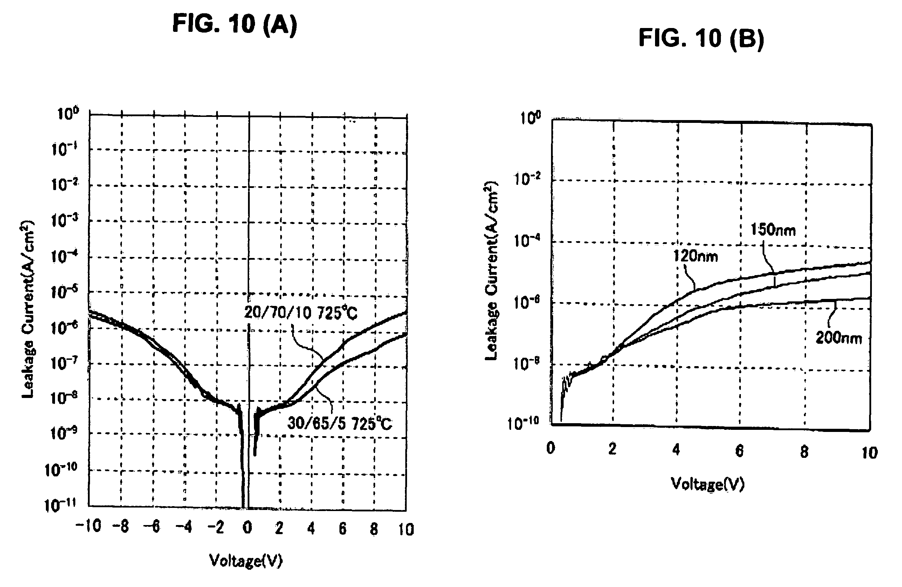

The leakage characteristics were also very good at $5 \times 10^{-8}$ to $7 \times 10^{-9}$ A/cm$^2$ when 2 V (saturation) was applied thereto, regardless of the film composition and film thickness, as shown in FIGS. 10 (A) and 10 (B).

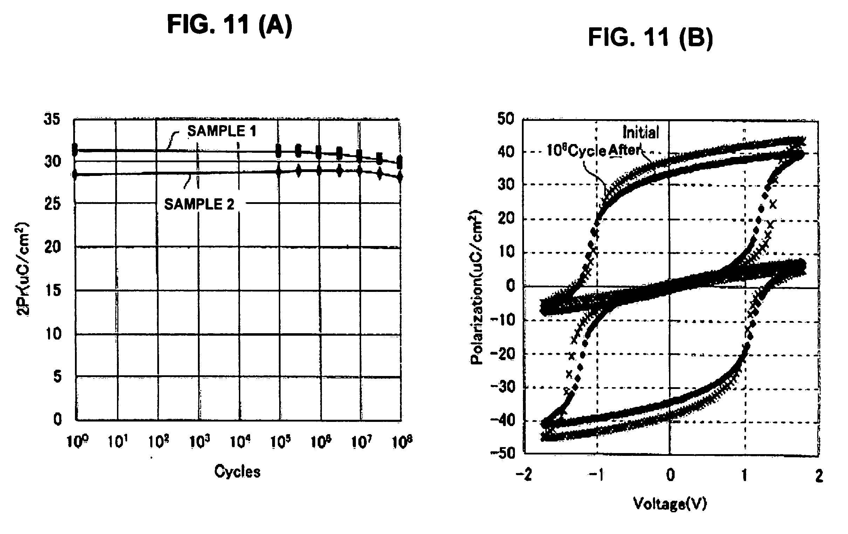

Next, the fatigue characteristics and static imprinting of $PbZr_{0.2}Ti_{0.6}Nb_{0.2}O_3$ thin films were measured, and the results of measurements were also very good, as shown in FIGS. 11 (A) and 11 (B). In particular, the fatigue characteristics shown in FIG. 11 (A) are excellent, despite that Pt was used in the upper and lower electrodes.

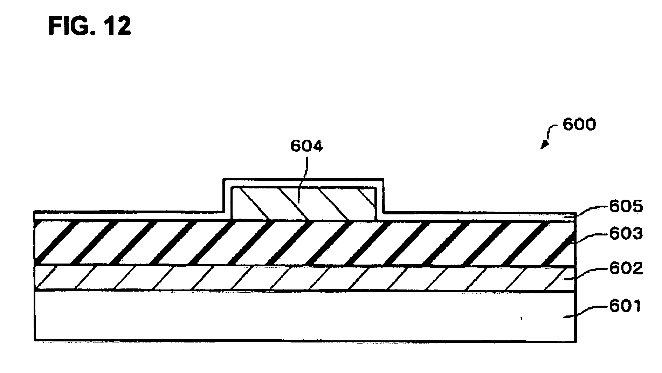

Further, as shown in FIG. 12, attempts were made to form an $SiO_2$ film 604 with ozone TEOS on a ferroelectric capacitor 600 including a lower electrode 602, a PZTN ferroelectric film 603 of the present example, and an upper electrode 605 formed over a substrate 601. It is known in the art that, if an $SiO_2$ film is formed with ozone TEOS on PZT, hydrogen generated from the TEOS penetrates the upper Pt and reduces the PZT, such that the PZT crystal is destroyed to the extent that the hysteresis phenomenon does not occur at all.

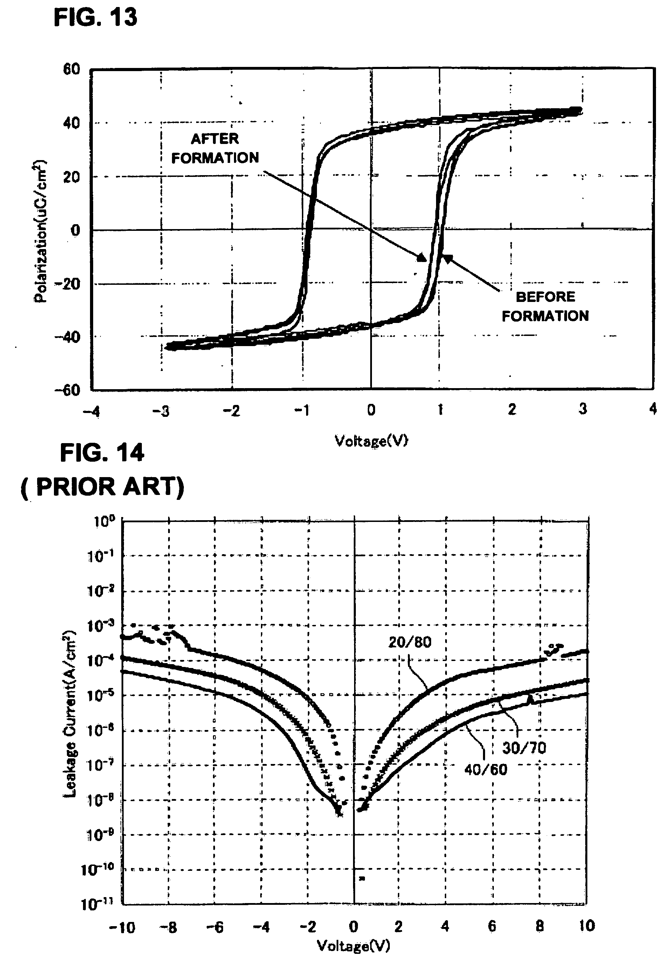

With the PZTN ferroelectric film 603 of the present example, however, the favorable hysteresis is maintained with substantially no deterioration, as shown in FIG. 13. In other words, it is found that the PZTN ferroelectric film 603 of the present embodiment also has a strong resistance to reduction. If the proportion of Nb in the tetragonal PZTN ferroelectric film 603 of the present invention does not exceed 40 mol %, a favorable hysteresis in proportion to the quantity of Nb added was obtained.

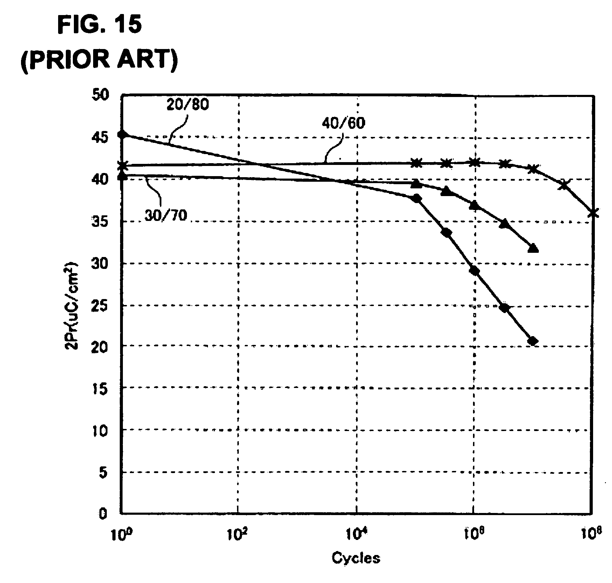

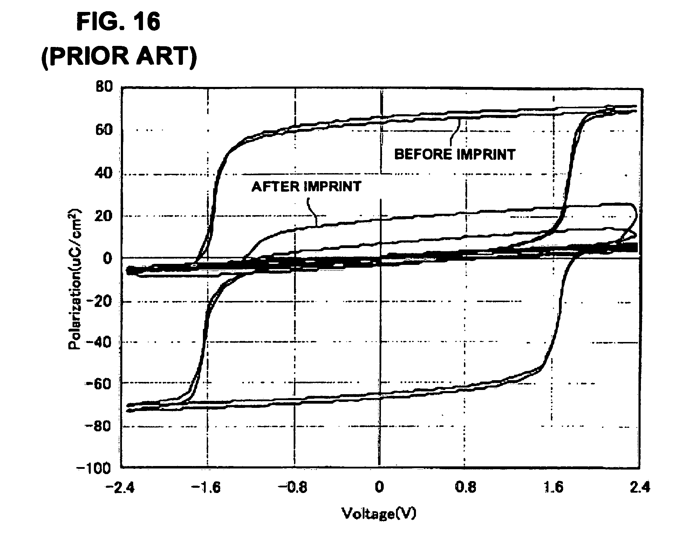

Evaluation of conventional PZT ferroelectric films was conducted for comparison. The conventional PZT samples were set to Pb : Zr : Ti ratios of 1 : 0.2 : 0.8, 1 : 0.3 : 0.7, and 1 : 0.6 : 0.4. As to the leakage characteristics thereof, it was found that the leakage characteristics deteriorated with increasing Ti content, as shown in FIG. 14, and became $10^{-5}$ A/cm$^2$ when the Ti content was 80% and 2V was applied, making it unsuitable for memory applications. Similarly, the fatigue characteristics deteriorated with increasing Ti content, as shown in FIG. 15. After imprinting, it was found that the data could hardly be read out, as indicated in FIG. 16.

As is clear from the above-described examples, the PZTN ferroelectric films in accordance with the present examples not only solved the problems of increase in leakage current and deterioration in imprint characteristics, which were thought to be inherent to PZT in the prior art, but also made it possible to use tetragonal PZT, which had not been used for the reasons described above, in memory usages regardless of the memory type or configuration. In addition, the material of the present embodiment can also be applied to piezoelectric element usages in which tetragonal PZT could not be used before for the same reasons.

(2) Example 2

The present example compares the ferroelectric characteristics obtained when the amount of Nb added to the PZTN ferroelectric film was varied from 0, 5, 10, 20, 30 to 40 mol %. 5 mol % PbSiO$_3$ silicate was added to all of the test pieces. In addition, methyl succinate was added to the sol-gel solutions for forming the ferroelectric films, which includes raw materials for film formation, to adjust the pH to 6. The entire film forming flow shown in FIG. 2 described above was used.

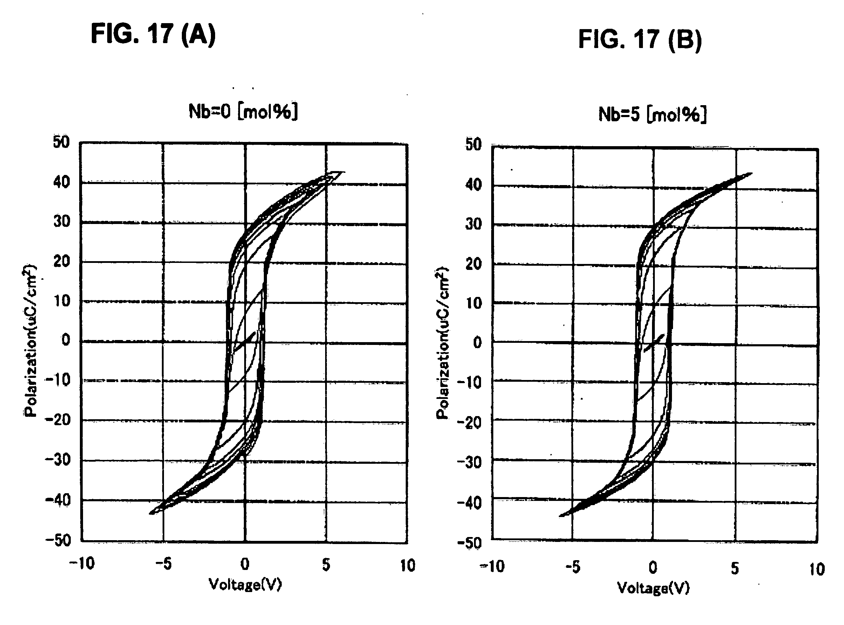

Measured hysteresis characteristics of PZTN ferroelectric films in accordance with the present example are shown in FIGS. 17 to 19.

As indicated in FIG. 17 (A), when the amount of Nb added was 0, a leaky hysteresis was obtained, whereas, as indicated in FIG. 17 (B), a good hysteresis characteristic with a high level of insulation was obtained when the amount of Nb added was 5 mol %.

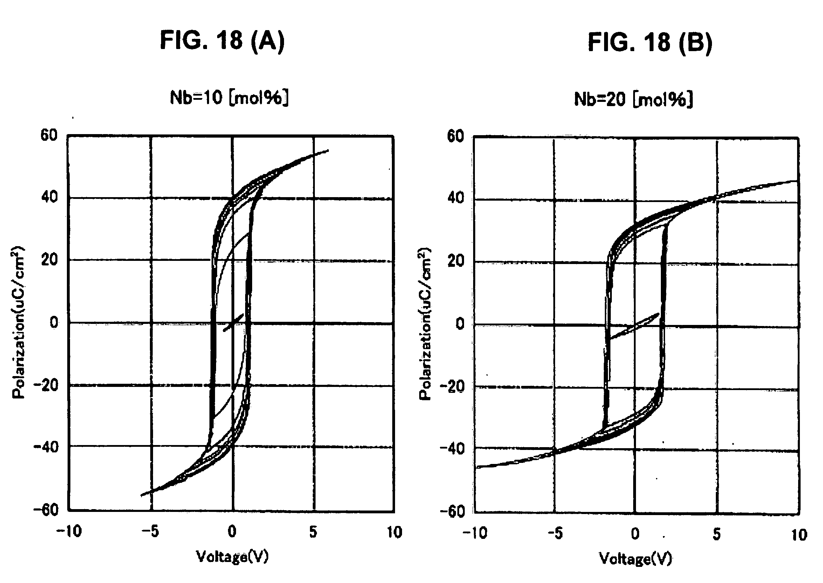

Also, as indicated in FIG. 18 (A), substantially no change was observed in the ferroelectric characteristic until the amount of Nb added reached 10 mol %. Even when the amount of Nb added was 0, no change was observed in the ferroelectric characteristic, thought it was leaky. When the amount of Nb added was 20 mol %, a hysteresis characteristic with an excellent squareness was obtained, as indicated in FIG. 18 (B).

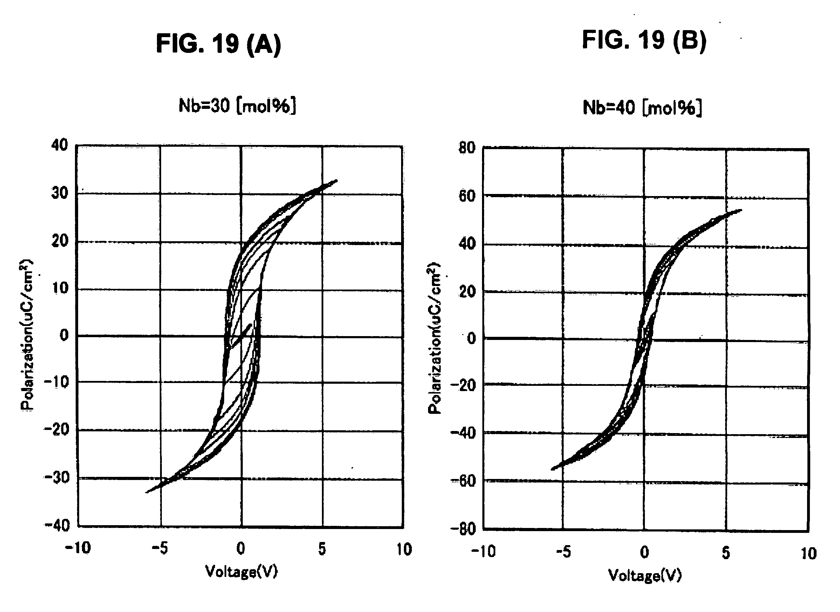

However, it was confirmed that when the amount of Nb added exceeded 20 mol %, the hysteresis characteristic greatly changed and became deteriorated, as indicated in FIGS. 19 (A) and 19 (B).

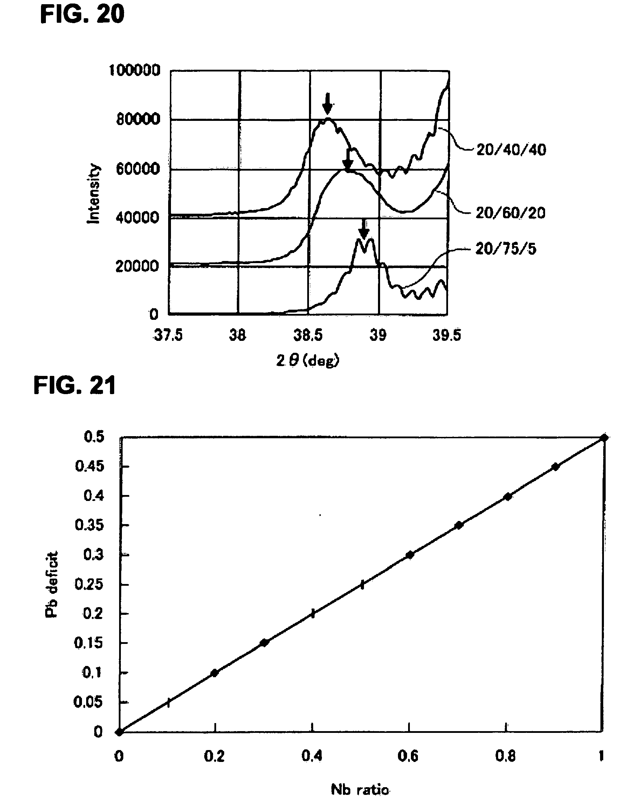

Then, X-ray diffraction patterns were compared, as shown in FIG. 20. When the amount of Nb added was 5 mol % (Zr/Ti/Nb = 20/75/5), the (111) peak position did not change from that of a PZT film of the prior art in which no Nb is added, but the (111) peak shifted towards a lower angle side as the amount of Nb added was increased to 20 mol % (Zr/Ti/Nb = 20/60/20) and 40 mol % (Zr/Ti/Nb = 20/40/40). In other words, it was found that the actual crystal system was rhombohedral, although the PZT composition was Ti-rich and in a tetragonal region. It was also observed that the ferroelectric characteristics changed as the crystal system changed.

In addition, when 45 mol % Nb was added, a hysteresis did not open and ferroelectric characteristics could not be confirmed (not shown).

PZTN films of the present invention have a very high level of insulation property, as already mentioned above. In this respect, conditions for PZTN to be dielectric were obtained, and the results shown FIG. 21 were obtained.

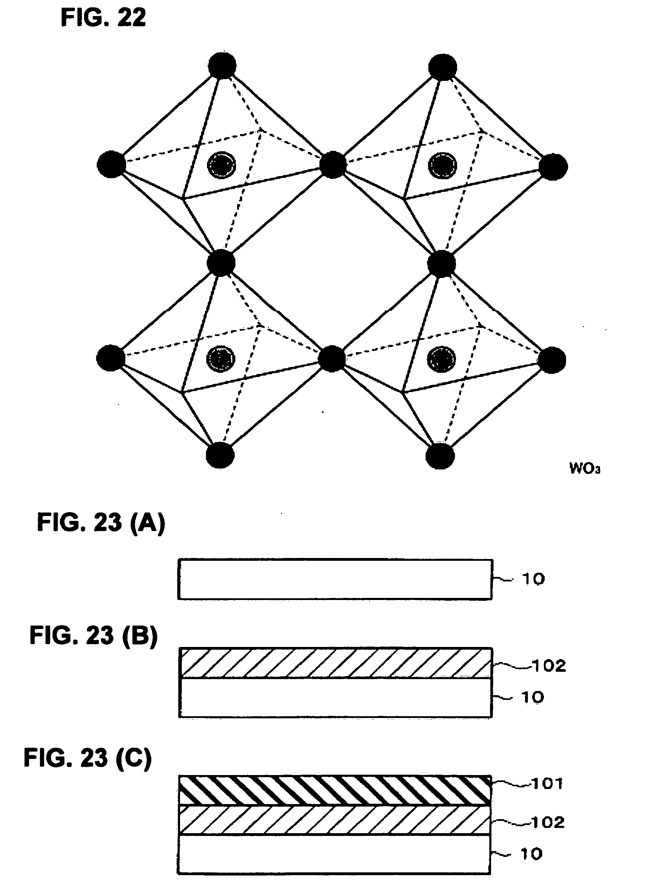

That is, the PZTN films of the present invention have a very high level of dielectric property, which means that Nb is added to Ti sites in a composition ratio equivalent to twice the amount of vacancies of Pb. Also, a perovskite crystal structure can be established even when 100 % of A site ions are vacated, as is understood from the crystal structure of WO$_3$ shown in FIG. 22, and it is known that the crystal system of WO$_3$ would readily change.

Accordingly, in the case of PZTN, the addition of Nb enables active control of Pb vacancies, and also controls the crystal system.

This indicates that the PZTN film of the present example would also be very useful when applied to piezoelectric elements. In general, when PZT is applied to piezoelectric elements, a rhombohedral crystal region with a Zr-rich composition is used. In this case, Zr-rich PZT is called soft PZT. This literally means that the crystal is soft. For example, when soft PZT is used in a nozzle that ejects ink in an inkjet printer, ink having a high viscosity cannot be pushed out because soft PZT is too soft and gives way to pressure of the ink.

Ti-rich tetragonal PZT, on the other hand, is called hard PZT, which means to be hard and brittle. However, while the PZTN film of the present invention is hard, the crystal system can be artificially changed into rhombohedral. In addition, the crystal system can be arbitrarily changed by the amount of Nb to be added and a Ti-rich PZT-system ferroelectric film has a small relative dielectric constant, such that devices can be driven at a low voltage.

This makes it possible to use hard PZT in applications where it could not be used previously, such as, in ink ejection nozzles of an inkjet printer. In addition, since Nb makes PZT softer, it is possible to provide PZT that is adequately hard, but not brittle.

Lastly, as described above, in accordance with the present example, not only Nb but also a silicate may be added at the same time with the addition of Nb, whereby the crystallization temperature can be reduced.

(3) Example 3

In the present example, the possibility of using a PZTN film was investigated from the viewpoint of lattice matching, for example, when the PZTN film is formed on a metal film composed of a platinum-system metal such as Pt, Ir or the like as an electrode material for a ferroelectric capacitor that forms a memory cell portion of a ferroelectric memory or a piezoelectric actuator that composes an ink ejection nozzle portion of an inkjet printer. Platinum-system metals act as underlayer films that decide the crystal orientation of ferroelectric films, and are also useful as electrode materials. However, since the lattice matching of the two materials are not sufficient, there may be a problem concerning fatigue characteristics of ferroelectric films when applied to devices.

In this case, the present inventors have developed a technique designed to ameliorate lattice mismatches between a PZT-system ferroelectric film and a platinum-system metal thin film, by incorporating Nb into the constituent elements of the PZT-system ferroelectric film. The process of manufacturing this PZT-system ferroelectric film is shown in FIGS. 23 (A) to 23 (C).

First, a given substrate 10 is prepared, as shown in FIG. 23 (A). A TiOx layer formed on an SOI substrate is used as the substrate 10. It is noted that a preferred material can be selected from known materials as the substrate 10.

Next, as shown in FIG. 23 (B), a metal film (first electrode) 102 composed of Pt is formed by, for example, sputtering, on the substrate 10, and then a PZTN film is formed as a ferroelectric film 101 on the metal film 102, as shown in FIG. 23 (C). Sol-gel solutions can be used as the material for forming the PZTN film. More specifically, a mixture of a sol-gel solution for $PbZrO_3$, a sol-gel solution for $PbTiO_3$, and a sol-gel solution for $PbNbO_3$ is used. It is noted that because the PZTN film includes Nb as its constituent element, the crystallization temperature thereof is high. For that reason, to reduce the crystallization temperature, it is preferable to use the mixture with a sol-gel solution for $PbSiO_3$ further added thereto. In the present example, the aforementioned sol-gel mixed solution is coated on the Pt metal film 102 by a spin-coat method, and then is subjected to a predetermined heat treatment to crystallize it. The flow of film forming processing is similar to the one shown in FIG. 2.

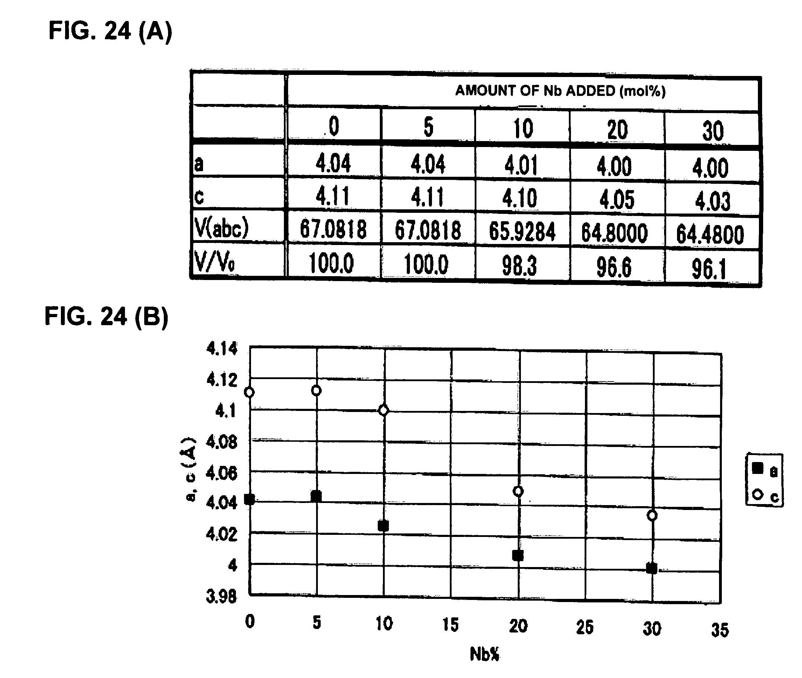

In the present example, crystal lattice constants of PZTN films obtained wherein the amount of Nb added ranged from 0 mol% to 30 mol% were measured by using an X-ray diffraction method, and the results shown in FIGS. 24 (A) and 24 (B) were obtained. It is observed from FIGS. 24 (A) and 24 (B) that the lattice constant along the a axis (or the b axis) becomes closer to the lattice constant along the c axis as the amount of Nb added increases. Also, V (abc) in FIG. 24 (A) is an index of a volumetric conversion of lattice constant (a,b,c). $V/V_0$ in FIG. 24 (A) is the ratio of the index V(abc) of the PZTN crystal with respect to an index $V_0$ which is a volumetric conversion of lattice constant of a PZT crystal in which no Nb is added. In this manner, it can be confirmed from the V(abc) and $V/V_0$ columns that the crystal lattice of the PZTN crystal becomes smaller as the amount of Nb added increases.

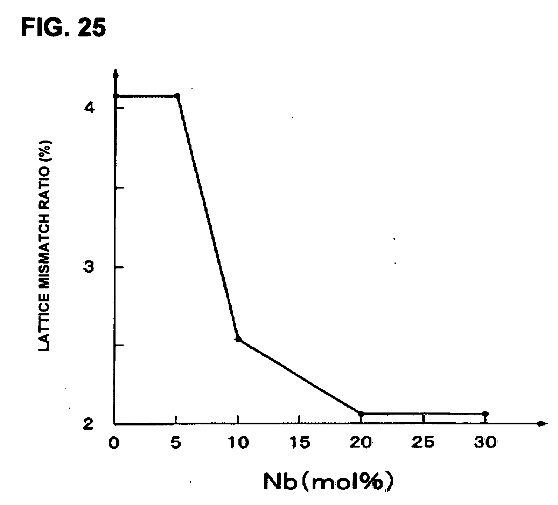

Lattice mismatch ratios with respect to a lattice constant (a,b,c = 3.96) of a Pt metal film were calculated based on the lattice constants of PZTN films formed with the addition of Nb in this manner, and the amounts of Nb added (mol %) were plotted along the horizontal axis in FIG. 25. It was confirmed from FIG. 25 that the effects of including Nb into a PZT-system ferroelectric film are not limited to the effect of improving the ferroelectric characteristic of each of the above described embodiments, but also include the effect of approximating the lattice constant thereof to the lattice constant of crystals of platinum-system metals such as Pt. It was confirmed that this effect is particularly obvious in the region in which the amount of Nb added is 5 mol % or greater.

It is therefore confirmed that the use of the method of the present invention reduces lattice mismatches between the metal film that is the electrode material and the ferroelectric film, and the lattice mismatch ratio can be improved to about 2% when the amount of Nb added is 30 mol %, for example. It is believed that, because strong bonds having both ionic bonds and covalence bonds between Nb atoms that substitute for Ti atoms at the B sites and oxygen atoms in the PZTN crystal structure are generated, and these bonds act in directions that compress the crystal lattice, causing changes in the direction in which the lattice constant decreases.

In addition, platinum-system metals such as Pt are chemically stable substances that are ideal as electrode materials for ferroelectric memories and piezoelectric actuators, so that the method of the present example makes it possible to alleviate lattice mismatches more than the prior art, even when a PZTN film is formed directly on this Pt metal film, and also improves the interface characteristic thereof. The method of the present example therefore makes it possible to reduce fatigue deterioration of PZT-system ferroelectric films, making it suitable for application to devices such as ferroelectric memories and piezoelectric actuators.

(4) Example 4

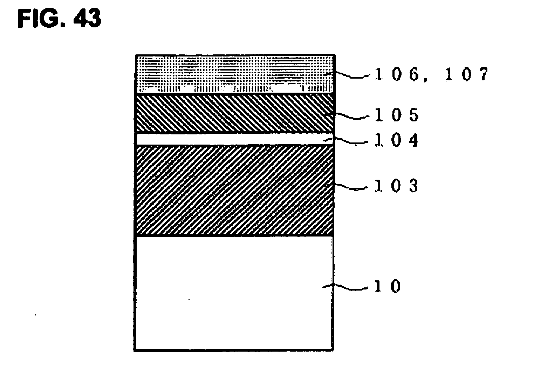

Samples having a structure shown in FIG. 43 were manufactured, and proportions of each element in the direction of depth were analyzed by a variety of methods. A method for manufacturing the samples is described below.

The surface of a silicon substrate 10 was thermally oxidized, whereby a silicon oxide layer 103 having a film thickness of about 400 nm was formed. Titanium was sputtered in a film on the silicon oxide layer 103, and the film was sintered in oxygen, whereby a titanium oxide layer 104 having a thickness of about 40 nm was formed. By a two-stage film forming method that combines an ion sputter method and a vapor deposition method, a platinum layer (electrode) 105 having a film thickness of about 150 nm was formed on the titanium oxide layer 104.

Then, $PbZr_{0.2}Ti_{0.6}Nb_{0.2}O_3$ (PZTN) was formed in a film on the platinum layer 105, and sintered in oxygen at 725 °C for crystallization, thereby forming a ferroelectric film 106 having a film thickness of about 150 nm, whereby a sample of the present example was obtained. Also, layers up to the platinum layer 105 were formed in a similar manner, and further $PbZr_{0.2}Ti_{0.8}O_3$ (PZT) was formed in a film on the platinum layer 105, and sintered in oxygen at 725 °C for crystallization, thereby forming a ferroelectric layer 107 having a film thickness of about 150 nm, whereby a comparison sample was obtained.

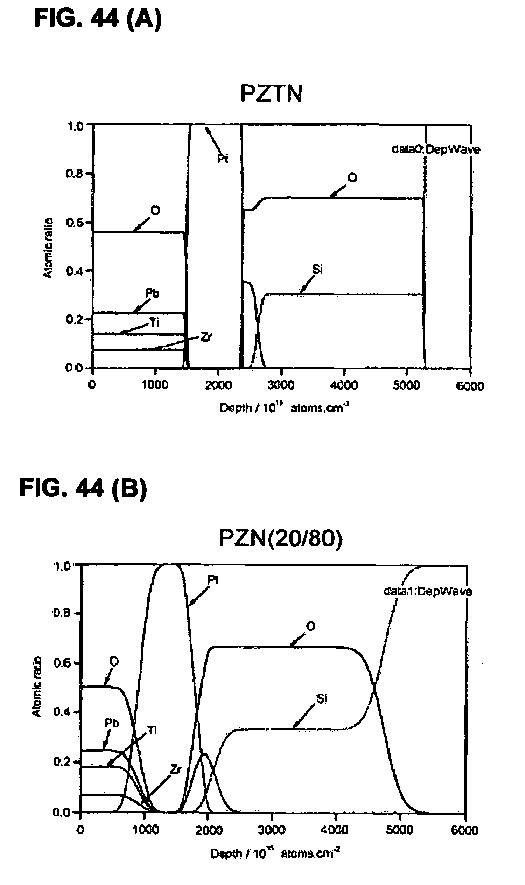

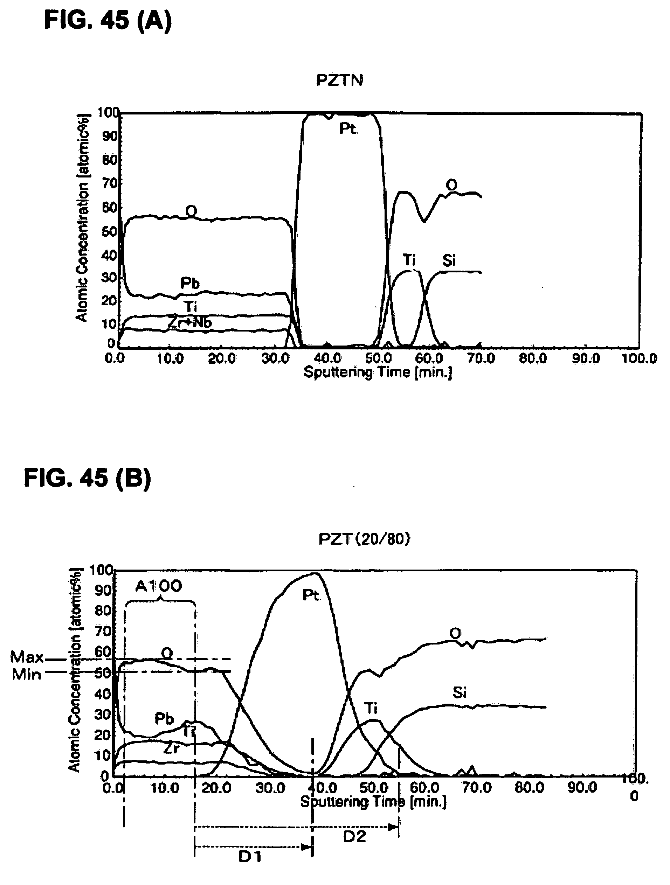

These samples were analyzed by RBS and NRA, and AES, respectively. FIGS. 44 (A) and (B) show the analysis results by RBS and NRA. FIG. 44 (A) shows the analysis results of PZTN, and FIG. 44 (B) shows the analysis results of PZT. Also, FIGS. 45 (A) and (B) show the analysis results by AES. FIG. 45 (A) shows the analysis results of PZTN, and FIG. 45 (B) shows the analysis results of PZT. It is noted that, in either of the analysis methods, because Zr and Nb whose atomic weights are close to each other cannot be completely distinguished, both are detected together.

From the results shown in FIGS. 44 (A) and (B), and FIGS. 45 (A) and (B), diffusion lengths of oxygen atoms to the electrode and difference in proportions of oxygen atoms in the ferroelectric films in the samples of the example and comparison example were obtained. Methods to obtain these values are described below.

(1) Diffusion Length of Oxygen Atoms

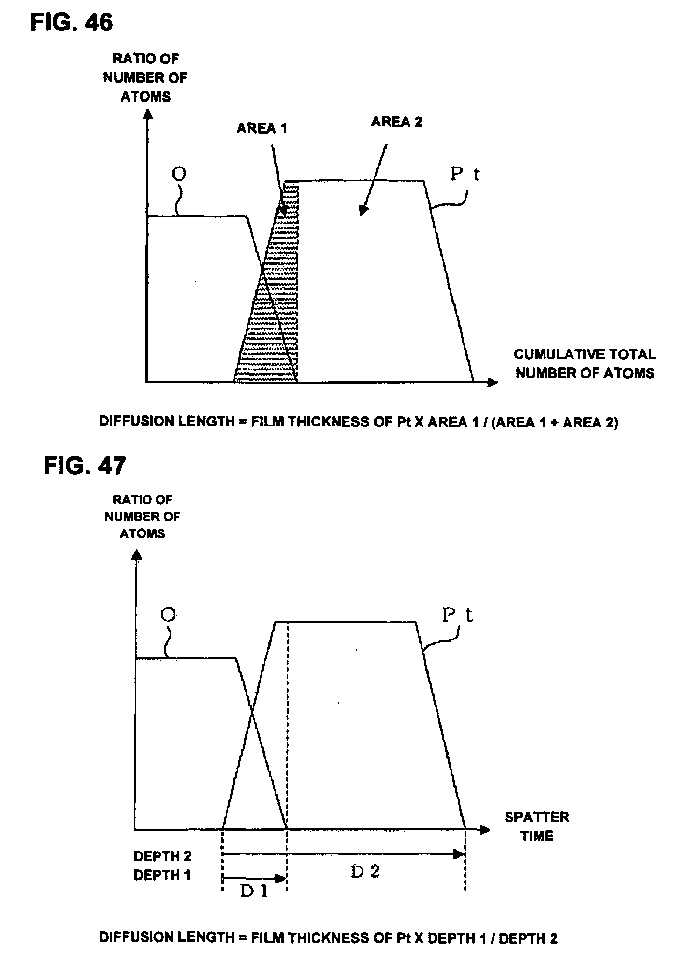

Diffusion lengths of oxygen atoms in the electrode (platinum layer) were obtained by methods indicated in FIG. 46 and FIG. 47.

According to the analysis method that combines RBS and NRA, because the profile is specified by the total number of atoms, the diffusion length can be obtained by comparing areas of the peaks. More specifically, as shown in FIG. 46, an area of the platinum peak in a region where the skirt of the peak of oxygen atoms and the skirt of the peak of platinum atoms overlap each other is assumed to be "Area 1," and the total area of the platinum peak is assumed to be "Area 2," the diffusion length can be obtained by Formula (1) as follows.

$$\text{Diffusion length} = \text{Film thickness of platinum layer} \times \text{Area 1} / (\text{Area 1} + \text{Area 2}) \qquad (1)$$

Also, since the depth is specified by the sputtering time in AES, the diffusion length is obtained by comparing lengths, while assuming that the sputter rate is constant. More specifically, as shown in FIG. 47, the width of depth of a region where the skirt of the peak of oxygen atoms and the skirt of the peak of platinum atoms overlap each other is assumed to be "Depth 1 (D1)," and the width of depth of the platinum peak is assumed to be "Depth 2 (D2)," the diffusion length can be obtained by Formula (2) as follows. D1 and D2 are shown in FIG. 45 (B) as a concrete example for easy understanding.

$$\text{Diffusion length} = \text{Film thickness of platinum layer} \times \text{Depth 1} / \text{Depth 2} \qquad (2)$$

By using Formulas (1) and (2) above, the diffusion length of oxygen atoms of the sample of the example was obtained by the RBS + NRA analysis, and it was 15 nm. The diffusion length of oxygen atoms of the sample of the example was also obtained by the AES analysis, and it was 30 nm. In contrast, the diffusion length of oxygen atoms of the sample of the comparison example obtained by the RBS + NRA analysis was about 70 nm, and it was 90 nm by the AES analysis.

As seen from the above, in either of the analysis methods, it was confirmed that the diffusion length of oxygen in the sample of the example according to the invention was substantially shorter compared with the diffusion length of oxygen in the sample of the comparison example.

The present example was conducted by using the samples that were heat-treated under the condition of high temperature (725 °C), and the numerical values of the above-described diffusion lengths of oxygen atoms therefore were obtained under severe conditions. Therefore, if samples of the example are made by other conditions, it is predicted that the diffusion lengths of oxygen atoms thereof obtained by the RBS + NRA analysis would be 15 nm or less. Also, similarly, it is predicted that the diffusion lengths of oxygen atoms of samples of the present example made by other conditions obtained by the AES analysis would be 30 nm or less.

(2) Difference in Proportions of Oxygen Atoms

A difference in proportions of oxygen atoms in the ferroelectric film was obtained by Formula (3) as follows. In the following formula, "Maximum value" and "Minimum value" indicate the maximum value and the minimum value of the oxygen peak in a region excluding the diffusion areas. For example, as shown in FIG. 45 (B), the maximum value (Max) and the minimum value (Min) are obtained in a region A100 among the oxygen peak excluding regions where lead noticeably diffuses and platinum diffuses.

$$\text{Difference} = (\text{Max} - \text{Min}) / (\text{Average of Max and Min}) \qquad (3)$$

By using Formula (3) above, the difference in proportions of oxygen atoms of the sample of the example was obtained according to the RBS + NRA analysis, and it was 1 %. The difference in proportions of oxygen atoms of the sample of the example was also obtained by the AES analysis, and it was 3 %. In contrast, though the difference in proportions of oxygen atoms of the sample of the comparison example obtained according to the RBS + NRA analysis did not show a substantial difference compared with the examples (however, the number of oxygen atoms that existed in the diffusion area was considerably larger compared with the examples), it was confirmed that there was a difference of 8% according to the AES analysis.

The present example was conducted by using the samples that were heat-treated under a high temperature condition (at 725 °C), and the numerical values of the above-described difference in proportions of oxygen atoms were thus obtained under severe conditions. Therefore, if samples of the example are made by other conditions, it is predicted that the difference in proportions of oxygen atoms thereof obtained by the RBS + NRA analysis would be 1 % or less. Similarly, it is predicted that the difference in proportions of oxygen atoms of samples of the present example made by other conditions obtained according to the AES analysis would be 8 % or less.

As indicated above, according to the AES analysis, in particular, it was confirmed that the difference of oxygen atoms in the samples of the example is considerably small compared with the difference of oxygen atoms in the sample of the comparison example. Therefore, it was confirmed that the ferroelectric thin film according to the present invention has an almost constant distribution of proportion of oxygen atoms in the direction of depth of the ferroelectric thin film.

The difference between the above-described PZTN and PZT is considered to be derived from the following reasons.

When diffusion of an element at the interface of solid materials is considered, and the diffusion coefficient is assumed to be D, D can be expressed by $D = a^2/t \cdot \exp(-E/kT)$, where a is the distance between particles, $1/t$ is the frequency in which a leap between particles occurs, and E is the activation energy.

It is noted here that $1/t$ becomes greater by vacancies of the element. Therefore, the difference in the degree of diffusion between PZT and PZTN can be explained as follows.

When a PZT film is heat-treated, Pb and O escape from within the PZT film, and Pb and O vacancies are generated therein. In particular, when O vacancies are generated, scattering of O atoms occurs because O atoms more readily move than other elements. In addition, the balance of charge collapses by the O vacancies, such that Pb, Zr and Ti in the film becomes unstable. Further, the diffusion coefficients of these elements become larger.

In PZTN, in particular, the diffusion coefficient of O element can be suppressed in order to prevent O vacancies. For this reason, diffusion by heat-treatment can be considerably suppressed compared with the case of PZT. Thus, because PZTN has very few defects in its crystals, the PZTN film itself functions as an oxygen barrier film. For example, for a stacked type FeRAM, a complex electrode structure is currently needed in the technology to prevent oxidation of tungsten plugs, but the same can be omitted by using PZTN because of the characteristics of PZTN described above.

(5) Example 5

Ferroelectric (piezoelectric) films were manufactured by laminating $PbZr_{0.36}Ti_{0.44}Nb_{0.20}O_3$ (PZTN (36/44/20), Example) and $PbZr_{0.56}Ti_{0.44}O_3$ (PZT (56/44), Comparison Example) on Ir electrodes to a thickness of about 1 $\mu$m, respectively. Each of the piezoelectric films was manufactured by repeating steps of coating the solution by spin coat, and drying and degreasing the same until it reaches a desired film thickness, and subjecting the same to a rapid heat treatment at 750 °C to cause crystallization.

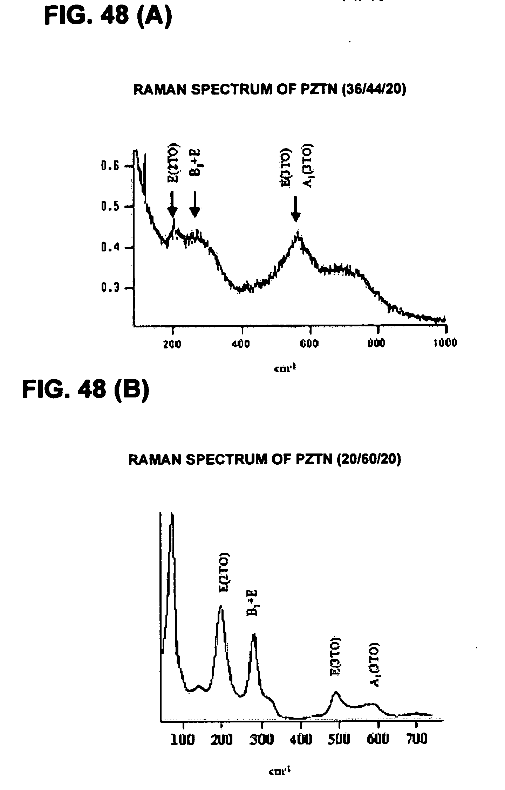

FIG. 48 (A) shows a Raman spectrum of the PZTN (36/44/20) film. The spectrum has one peak adjacent to 500 $cm^{-5}$. This is clearly different from a Raman spectrum of a tetragonal PZTN (20/60/20) film shown in FIG. 48 (B). It is understood from the above that the PZTN (36/44/20) is rhombohedral. Similarly, the PZT (56/44) was also rhombohedral.

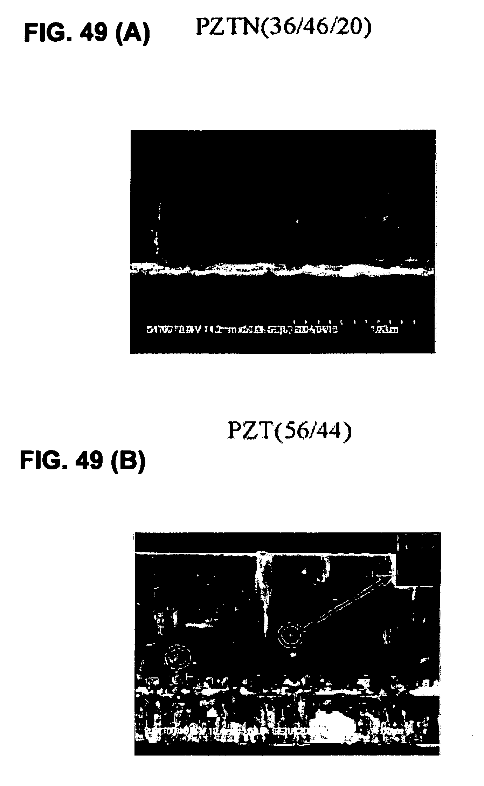

FIGS. 49 (A) and (B) show cross-sectional profiles taken by SEM of the PZTN (36/44/20) film and the PZT (56/44) film, respectively. The first difference is that the interface between the PZTN (36/44/20) film and the lower electrode is clear, but the interface between the PZT (56/44) film and the lower electrode is not clear. The second difference is that white dots that are believed to be caused by compositional shifts are observed in the film of the PZT (56/44) film, but such white dots are not observed in the PZTN (36/44/20) film. It is therefore considered from the above that the PZTN (36/44/20) film has more uniform compositions within the film than the PZT (56/44) film, and has less mutual diffusion with the electrode.

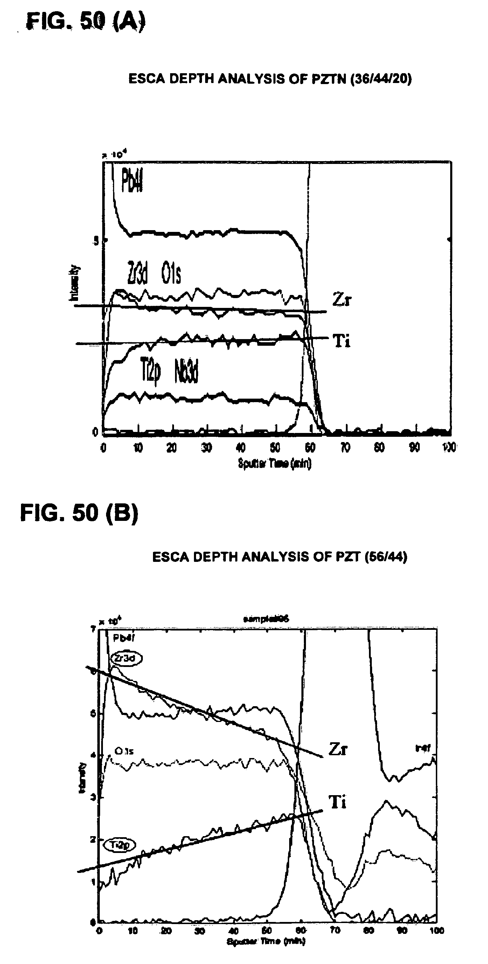

FIGS. 50 (A) and (B) show results of compositional analysis in the depth direction by ESCA (Electron Spectroscopy for Chemical Analysis) conducted on the PZTN (36/44/20) film and the PZT (56/44) film, respectively. The first difference is that fluctuations in the Zr and Ti compositions in the depth direction of the PZT (56/44) film are large, but all of the element compositions are present generally constantly in the depth direction of the PZTN (36/44/20) film. The second difference is that substantial mutual diffusion of the compositions is observed in the interface between the PZT (56/44) film and the electrode, but almost no mutual diffusion of the compositions is observed in the interface between the PZTN (36/44/20) film and the electrode. The differences in the cross-sectional profiles are clearly understood from these results.

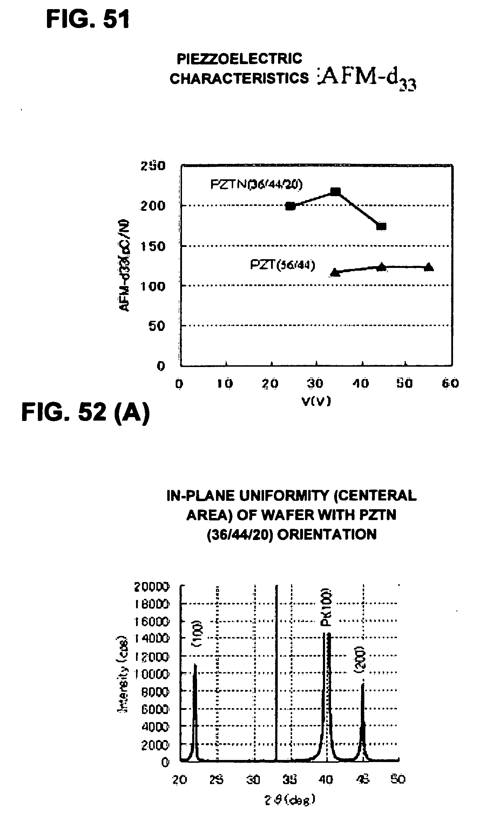

FIG. 51 shows piezoelectric characteristics ($d_{33}$) of the PZTN (36/44/20) film and the PZT (56/44) film. The PZTN (36/44/20) film has a larger $d_{33}$ compared to the PZT film. It is considered that this may happen because the PZTN (36/44/20) film is a softer material than the PZT (56/44) film, but it is rather considered that the above-described characteristics of the PZTN (36/44/20) film, i.e., the uniform compositions in the film and little mutual diffusion with the electrode, are more deeply related. The piezoelectric characteristics of films are generally inferior to those of bulk. It is considered that this happens because portions with higher piezoelectric constant and lower piezoelectric constant are formed in a film because heterogeneous phases originating from interface layers with an electrode and compositional shifts are generated in the film, such that displacements may be suppressed in the portions with lower piezoelectric constant. In other words, because formation of interface layers and heterogeneous phases is suppressed in the PZTN (36/44/20) film, it can better take full advantage of the original piezoelectric characteristics of the material than the PZT (56/44) film, which is believed to be linked to a large piezoelectric constant $d_{33}$ in the PZTN (36/44/20) film.

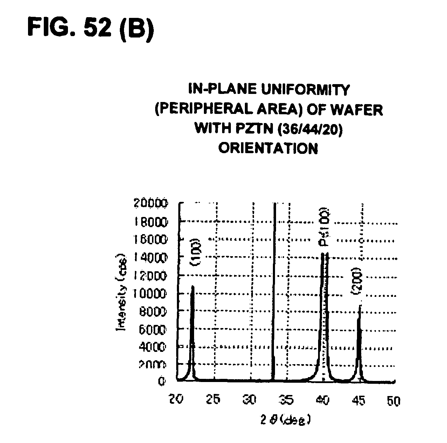

Also, the PZTN (36/44/20) film has uniform compositions in the film and clean interface with an electrode, and therefore has little compositional differences in a large area. As shown in FIGS. 52 (A) and (B), the PZTN (36/44/20) film on a 6-inch wafer has orientations that are generally equal in its central and peripheral areas, and therefore exhibit uniform orientations across the entire area of the wafer. This is one of the significant characteristics of the PZTN (36/44/20) film in view of the productivity.

Reference Example

In the present example, $PbZr_{0.4}Ti_{0.6}O_3$ ferroelectric films were manufactured.

According to the conventional method, a solution including about 20 % excess Pb is used, and this is to restrain volatile Pb and reduce the crystallization temperature. However, since it is unclear as to how the excess Pb acts in the completed thin films, the amount of excess Pb should be suppressed to a minimum.

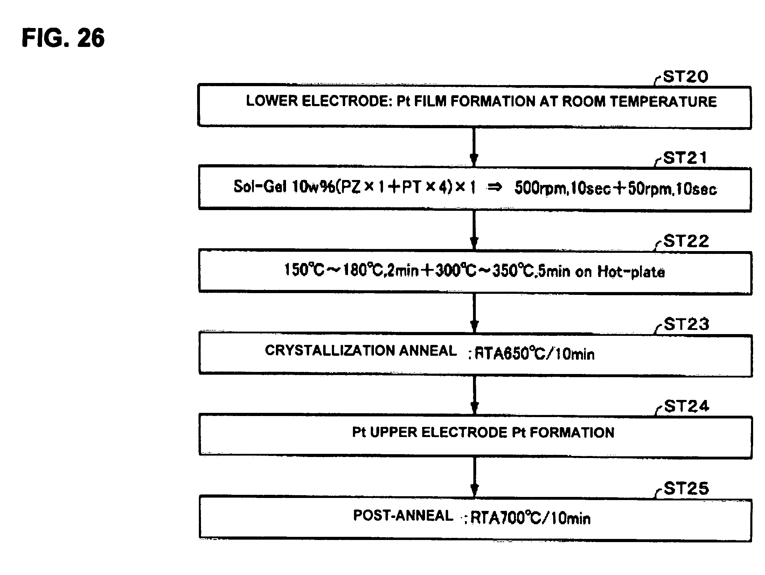

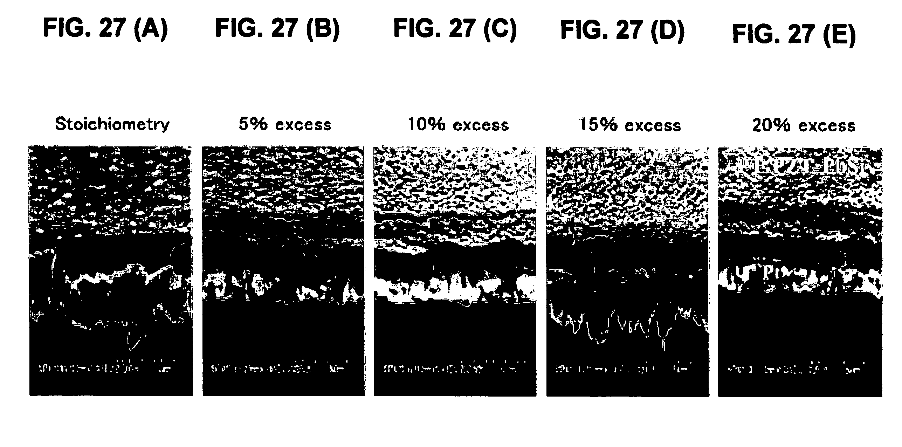

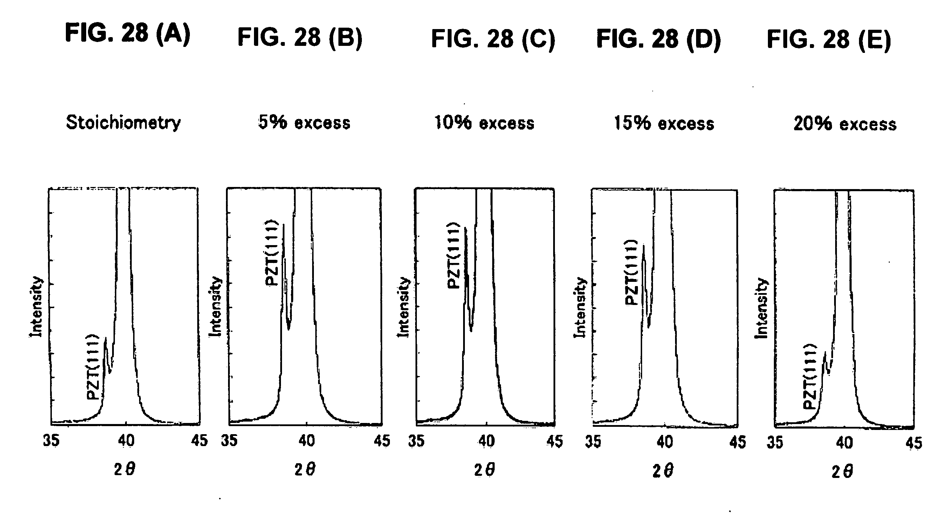

Accordingly, sol-gel solutions for forming $PbZr_{0.4}Ti_{0.6}O_3$ of 10 wt % concentration (solvent: n-butanol) containing an excess Pb of 0, 5, 10, 15, and 20%, respectively, to each of which was further added 1 mol % of a sol-gel solution for forming $PbSiO_3$ of 10 wt % concentration (solvent: n-butanol), were used to form $PbZr_{0.4}Ti_{0.6}O_3$ ferroelectric films having a thickness of 200 nm through conducting steps ST20 to ST25 shown in FIG. 26. Surface morphologies in this case are shown in FIGS. 27 (A) to 27 (C), and XRD patterns thereof are shown in FIGS. 28 (A) to 28 (C).

Although an excess Pb of about 20% was necessary in the prior art, it was indicated that crystallization proceeded sufficiently with an excess Pb of 5%. This indicates that the addition of merely 1 mol % of $PbSiO_3$ catalyst lowers the crystallization temperature of PZT, so that almost no excess Pb is needed. Hereafter, a solution containing an excess Pb of 5% is always used for forming PZT, $PbTiO_3$, and $Pb(Zr,Ti)O_3$

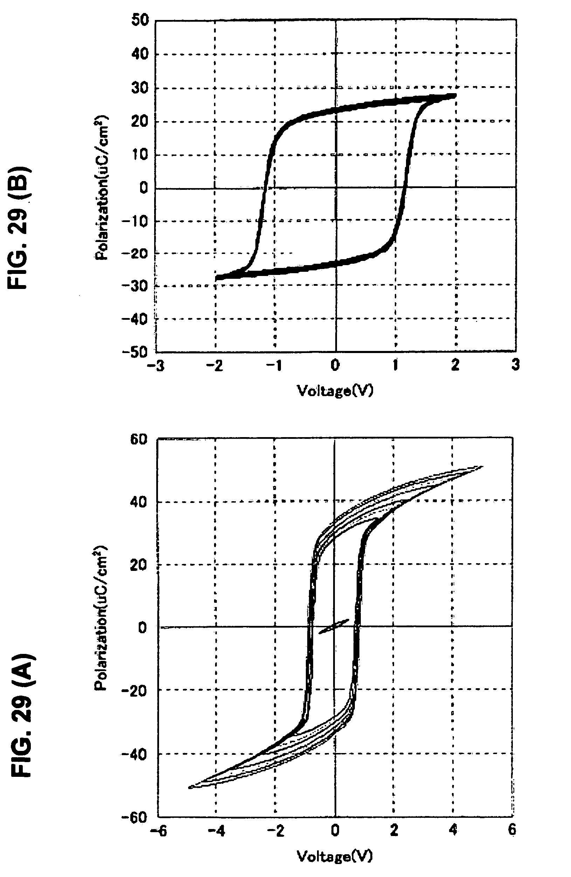

Next, a sol-gel solution for forming $PbZrO_3$ of 10 wt % concentration (solvent: n-butanol) and a sol-gel solution for forming $PbTiO_3$ of 10 wt % concentration (solvent: n-butanol) were mixed in the ratio of 4 : 6 to form a mixed solution, to which was further added 1 mol % of a sol-gel solution for forming $PbSiO_3$ of 10 wt % concentration (solvent: n-butanol). By using this mixed solution, $PbZr_{0.4}Ti_{0.6}O_3$ ferroelectric films having a thickness of 200 nm were manufactured in accordance with the process flow shown in FIG. 2. Their hysteresis characteristics in this case had good squareness, as shown in FIGS. 29 (A) and 29 (B). However, it was found that they were also leaky.

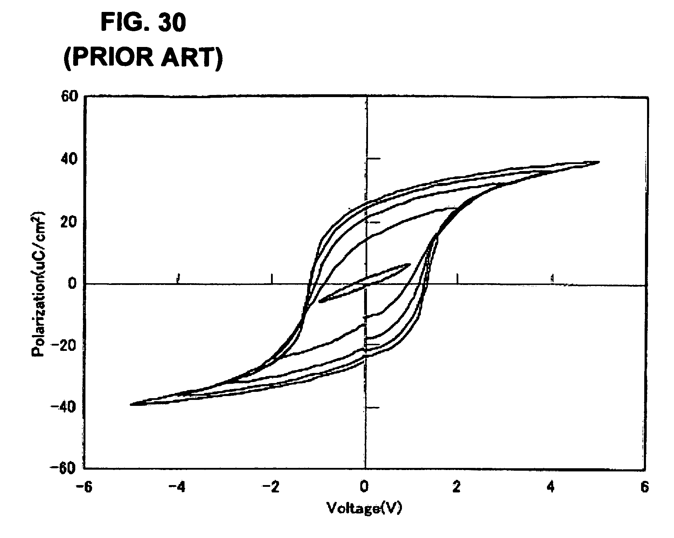

Further, for comparison, to a sol-gel solution for forming $PbZr_{0.4}Ti_{0.6}O_3$ of 10 wt % concentration (solvent: n-butanol) was added 1 mol % of a sol-gel solution for forming $PbSiO_3$ of 10 wt % concentration (solvent: n-butanol) to form a mixed solution, and by using the mixed solution, a $PbZr_{0.4}Ti_{0.6}O_3$ ferroelectric film having a thickness of 200 nm was manufactured by a conventional method and according to the above-described process flow of FIG. 26. As shown in FIG. 30, the hysteresis characteristic in this case was not particularly good.

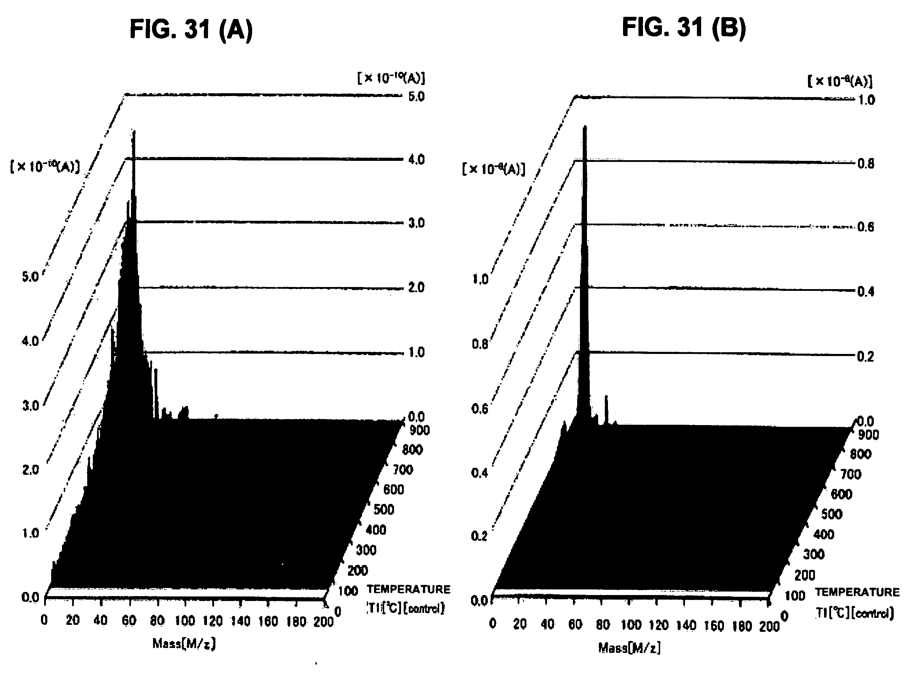

Then, degassing analysis was performed using each of these ferroelectric films, and the results shown in FIGS. 31 (A) and 31 (B) were obtained.

As shown in FIG. 31 (A), it was confirmed that the conventional ferroelectric films manufactured by PZT sol-gel solutions always had degassing with respect to H and C, from room temperature to elevated temperatures up to 1000 °C.

On the other hand, as shown in FIG. 31 (B), in the case of the ferroelectric films of the present invention formed by using a solution in which a sol-gel solution for forming $PbZrO_3$ of 10 wt % concentration (solvent: n-butanol) and a sol-gel solution for forming $PbTiO_3$ of 10 wt % concentration (solvent: n-butanol) are mixed in the ratio of 4 : 6, it was found that almost no degassing occurred until they dissolved.

The above is believed to have occurred because the use of a solution in which a sol-gel solution for forming $PbZrO_3$ of 10 wt % concentration (solvent: n-butanol) and a sol-gel solution for forming $PbTiO_3$ of 10 wt % concentration (solvent: n-butanol) are mixed in the ratio of 4 : 6 ensures that $PbTiO_3$ initially crystallizes on Pt from the sol-gel solution for forming $PbTiO_3$ of 10 wt % concentration (solvent: n-butanol) in the mixed solution, which become crystallization initial seeds, and also that lattice mismatches between Pt and PZT are cancelled, facilitating the crystallization of PZT. It is also considered that, by using the mixed solution, $PbTiO_3$ and PZT are continuously formed with an excellent interface, which is lead to the favorable squareness of hysteresis.

## 2. Ferroelectric Memory

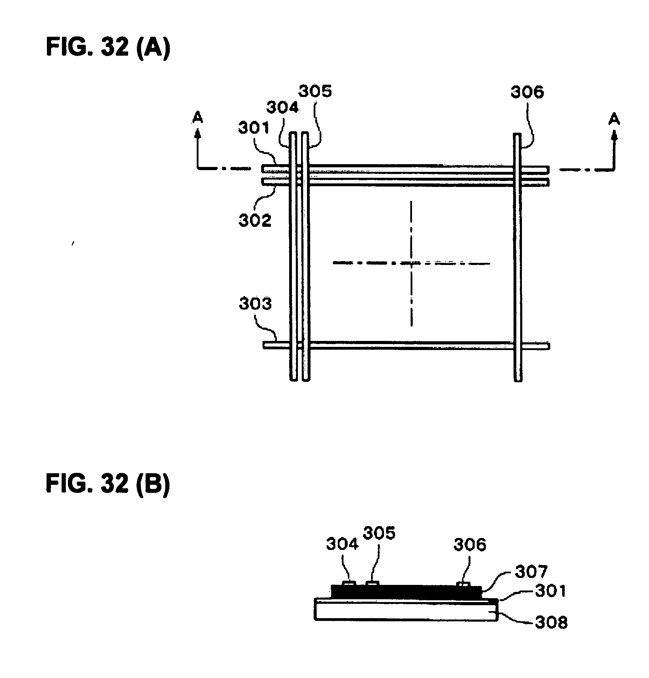

FIG. 32 (A) and FIG. 32 (B) are views showing the configuration of a simple matrix type ferroelectric memory device 300 in accordance with an embodiment of the present invention. FIG. 32 (A) is a plan view thereof, and FIG. 32 (B) is a cross-sectional view taken along line A - A shown in FIG. 32 (A). The ferroelectric memory device 300 includes, as shown in FIG. 32 (A) and FIG. 32 (B), a predetermined number of word lines 301 - 303 and a predetermined number of bit lines 304 - 306 arranged and formed on a substrate 308. A ferroelectric film 307 composed of the PZTN described above in the present embodiment is interposed between the word lines 301 - 303 and the bit lines 304 - 306, wherein ferroelectric capacitors are formed in intersecting regions of the word lines 301 - 303 and the bit lines 304 - 306.

In the ferroelectric memory device 300 in which memory cells are arranged in a simple matrix, writing in and reading from the ferroelectric capacitors formed in the intersecting regions of the word lines 301 - 303 and the bit lines 304 - 306 are performed by a peripheral driver circuit, reading amplifier circuit, and the like (not shown) (which are hereinafter called "peripheral circuit"). The peripheral circuit may be formed by MOS transistors on a substrate different from that of the memory cell array and connected with the word lines 301 - 303 and the bit lines 304 - 306, or by using a single crystal silicon substrate as the substrate 308, the peripheral circuit may be integrated on the same substrate with the memory cell array.

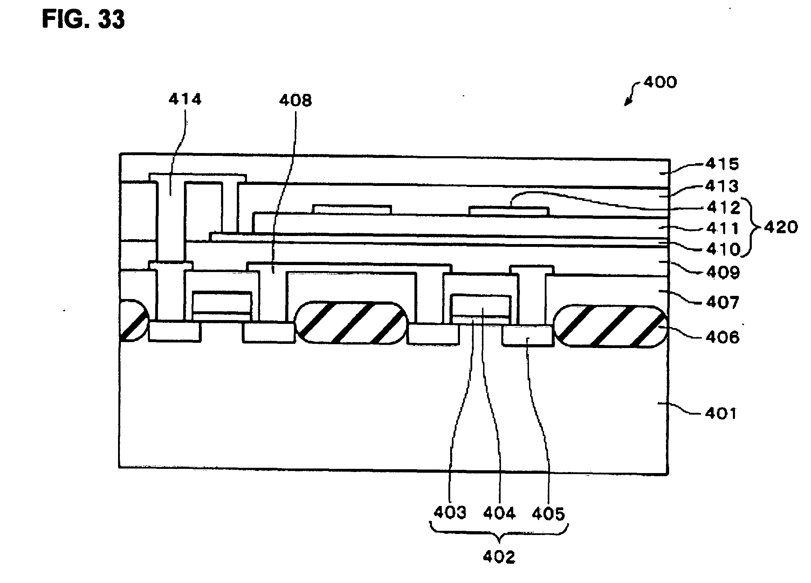

FIG. 33 is a cross-sectional view showing an example of a ferroelectric memory device 400 in accordance with the present embodiment in which a memory cell array is integrated with a peripheral circuit on the same substrate.

Referring to FIG. 33, MOS transistors 402 are formed on a single crystal silicon substrate 401, and the region where the transistors are formed defines a peripheral circuit section. The MOS transistor 402 is composed of a single crystal silicon substrate 401, source/drain regions 405, a gate dielectric film 403, and a gate electrode 404.

Also, the ferroelectric memory device 400 has an element isolation oxide film 406, a first interlayer dielectric film 407, a first wiring layer 408, and a second interlayer dielectric film 409.

Also, the ferroelectric memory device 400 has a memory cell array composed of ferroelectric capacitors 420, and each of the ferroelectric capacitors 420 is composed of a lower electrode (first electrode or second electrode) 410 that defines a word line or a bit line, a ferroelectric film 411 including ferroelectric phase and paraelectric phase, and an upper electrode (second electrode or first electrode) 412 that is formed on the ferroelectric film 411 and defines a bit line or a word line.

Furthermore, the ferroelectric memory device 400 has a third interlayer dielectric film 413 over the ferroelectric capacitor 420, and a second wiring layer 414 connects the memory cell array and the peripheral circuit section. It is noted that, in the ferroelectric memory device 400, a protection film 415 is formed over the third interlayer dielectric film 413 and the second wiring layer 414.

According to the ferroelectric memory device 400 having the structure described above, the memory cell array and the peripheral circuit section can be integrated on the same substrate. It is noted that, although the ferroelectric memory device 400 shown in FIG. 33 has a structure in which the memory cell array is formed over the peripheral circuit section, it may have a structure in which the memory cell array is not disposed over the peripheral circuit section, and may be in contact with the peripheral circuit section in a plane.

Because the ferroelectric capacitor 420 used in the present embodiment is formed from the PZTN in accordance with the present embodiment described above, its hysteresis has excellent squareness, and its disturbance characteristics are stable. Moreover, damage to the peripheral circuit and other elements is reduced due to the lowered process temperature, and process damage (reduction by hydrogen, in particular) is small, such that the ferroelectric capacitor 420 can suppress deterioration of the hysteresis that may be caused by such damages. Therefore, the simple matrix type ferroelectric memory device 400 can be put in practical use by using the ferroelectric capacitor 420.

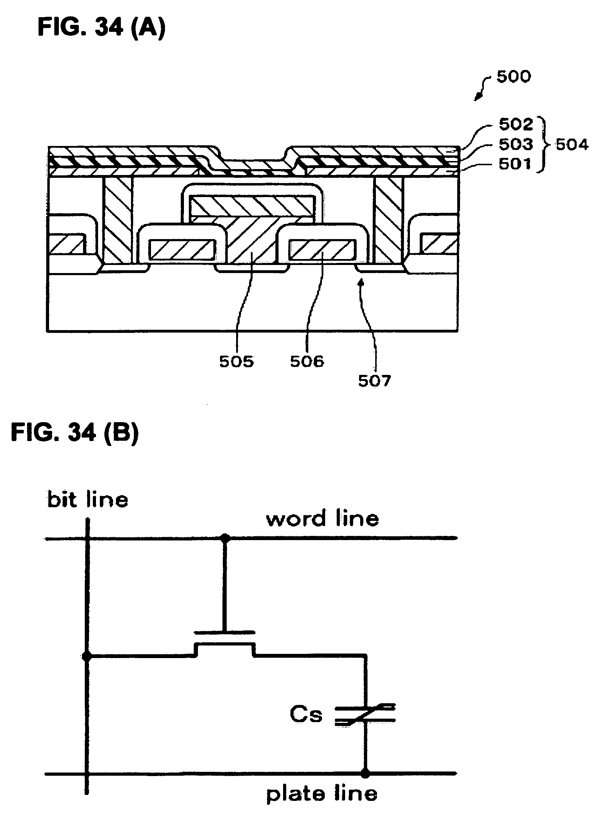

FIG. 34 (A) shows a structural drawing of a 1T1C type ferroelectric memory device 500 as a modified example. FIG. 34 (B) is an equivalent circuit diagram of the ferroelectric memory device 500.

As shown in FIGS. 34, the ferroelectric memory device 500 is a memory element having a structure similar to that of a DRAM, which is composed of a capacitor 504 (1C) comprising a lower electrode 501, an upper electrode 502 that is connected to a plate line, and a ferroelectric film 503 using a PZTN ferroelectric in accordance with the present embodiment, and a switching transistor element 507 (1T), having source/drain electrodes, one of them being connected to a data line 505, and a gate electrode 506 that is connected to a word line. The 1T1C type memory can perform writing and reading at high-speeds at 100 ns or less, and because written data is nonvolatile, it is promising as replacement of SRAM.

### 3. Piezoelectric Element and Ink-jet Recording Head

An ink-jet recording head in accordance with an embodiment of the present invention is described below in detail.

As an ink-jet recording head, in which a part of a pressure generating chamber communicating with a nozzle orifice that ejects ink droplets is formed from a vibration plate, this vibration plate is deformed by a piezoelectric element to pressurize ink in the pressure generating chamber, and ink droplets are ejected from the nozzle orifice, two types of recording heads are put into practical use.

One of them uses a piezoelectric actuator of a longitudinal vibration mode, which expands and contracts in the axis direction of the piezoelectric element, and the other uses a piezoelectric actuator of a flexural vibration mode.

As the one that uses an actuator of a flexural vibration mode, there is a known recording head in which a uniform piezoelectric layer is formed over the entire surface of a vibration plate by a film deposition technology, the piezoelectric layer is divided into shapes each corresponding to the pressure generating chamber by a lithography method, such that the piezoelectric elements are formed independently from one another for each of the pressure generating chambers.

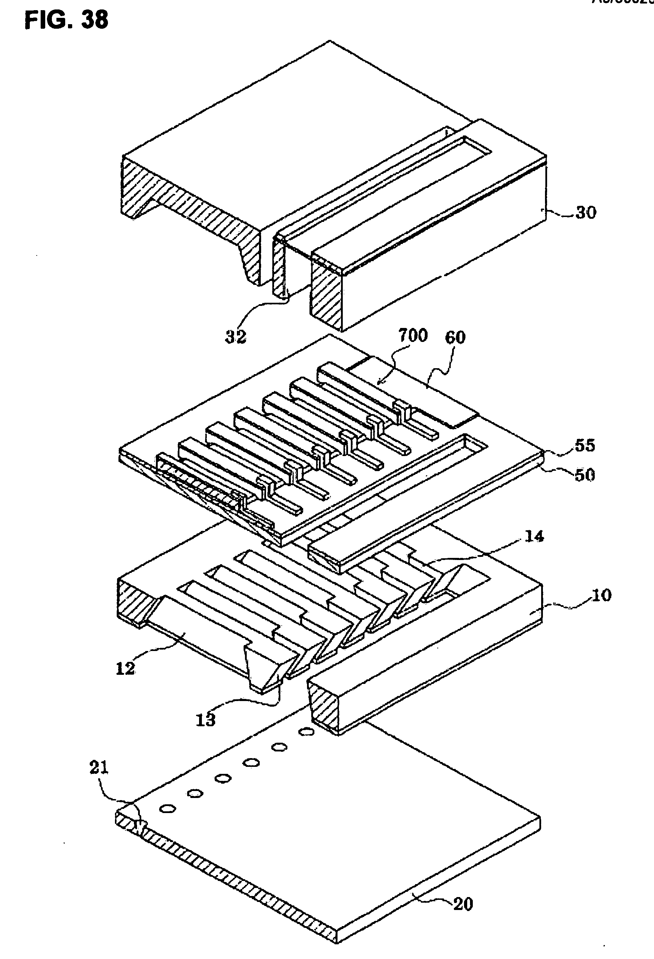

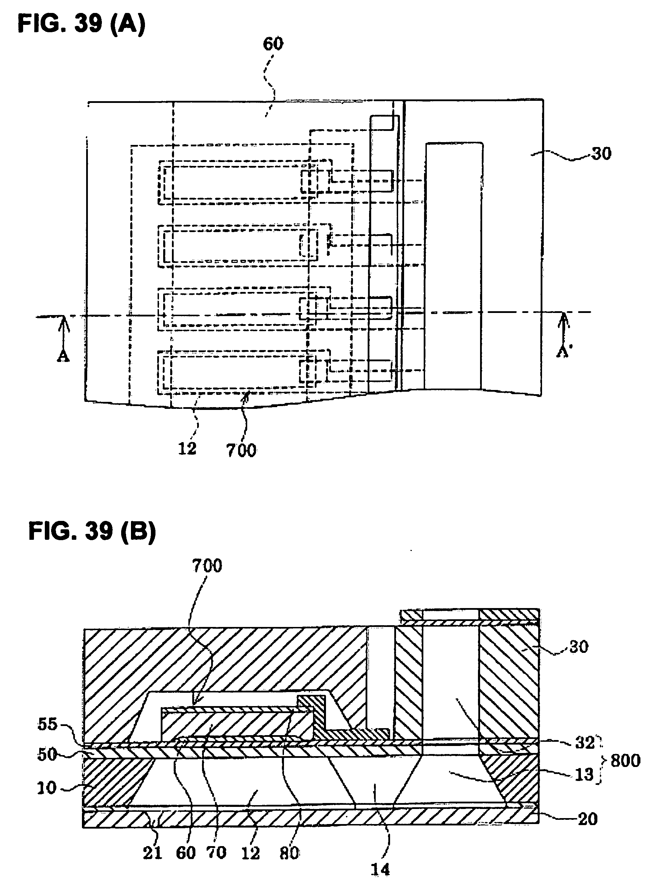

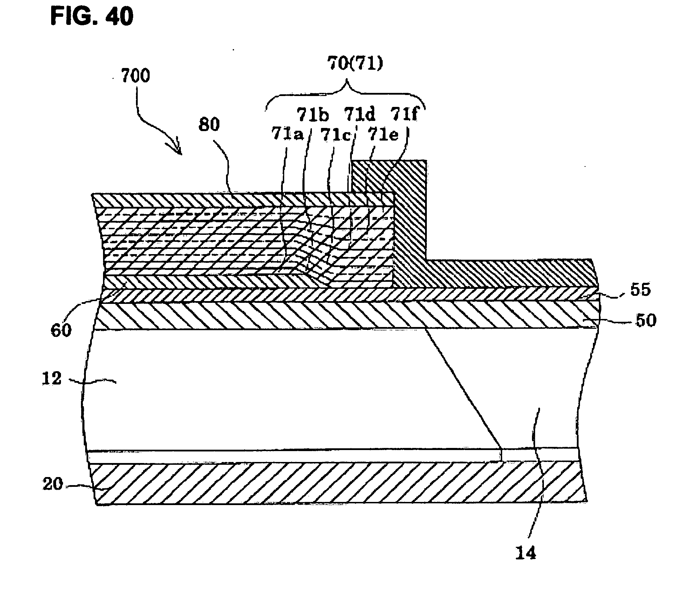

FIG. 38 is an exploded perspective view showing an ink-jet recording head in accordance with an embodiment of the present invention, and FIGS. 39 (A) and (B) are a plan view of FIG. 38 and a cross-sectional view taken along a line A - A of FIG. 39 (B), respectively, and FIG. 40 schematically shows a layered structure of a piezoelectric element 700. As shown in the figures, a passage-forming substrate 10 consists of a single crystal silicon substrate with a plane orientation (110) in accordance with the present embodiment, and on one surface thereof is formed an elastic film 50 having a thickness of 1 to 2 $\mu$m which consists of silicon dioxide previously formed by thermal oxidation. In the passage-forming substrate 10, a plurality of pressure generating chambers 12 are arranged in its width direction. Moreover, a communicating portion 13 is formed in an area outside and along the longitudinal direction of the pressure generating chambers 12 in the passage-forming substrate 10, and the communicating portion 13 and each of the pressure generating chambers 12 communicate with each other through an ink supply passage 14 provided for each of the pressure generating chambers 12. It is noted that the communicating portion 13 communicates with a reservoir portion 32 provided in a sealing substrate 30 to be described later and constitutes a part of a reservoir 800 that defines a common ink chamber to the respective pressure generating chambers 12. The ink supply passage 14 is formed with a width narrower than that of the pressure generating chamber 12, and maintains constant the passage resistance of ink flowing from the communicating portion 13 into the pressure generating chambers 12.

On the opening surface side of the passage-forming substrate 10, a nozzle plate 20 having nozzle orifices 21 perforated therein is fixedly adhered via an adhesive or a thermowelding film, each nozzle orifice 21 communicating with the respective pressure generating chamber 12 at an area adjacent to an end portion thereof on the opposite side of the ink supply passage 14.

The elastic film 50 described above having a thickness of, for example, about 1.0 $\mu$m, is provided on the passage-forming substrate 10 on the opposite side of the open surface thereof, and a dielectric film 55 having a thickness of, for example, about 0.4 μm, is provided on the elastic film 50. Further, on the dielectric film 55 is provided a lower electrode film 60 having a thickness of, for example, about 0.2 μm, a piezoelectric layer 70 having a thickness of, for example, about 1.0 μm, and an upper electrode film 80 having a thickness of, for example, about 0.05 μm, which are laminated by a process to be described below, thereby constituting the piezoelectric element 700. It is noted that the term piezoelectric element 700 refers to a portion including the lower electrode film 60, the piezoelectric layer 70 and the upper electrode film 80. In general, one of the electrodes of the piezoelectric element 300 is used as a common electrode, and the other electrode and the piezoelectric layer 70 are patterned for each pressure generating chamber 12. It is noted here that the portion which is constituted by the piezoelectric layer 70 and one of the patterned electrodes and causes piezoelectric strain by applications of voltages to the electrodes is called a piezoelectric active portion. In the present embodiment, the lower electrode film 60 is used as the common electrode of the piezoelectric element 700, and the upper electrode film 80 is used as discrete electrodes of the piezoelectric element 700. However, their relation may be reversed without any trouble for the sake of convenience of wiring and a driving circuit. In any case, an piezoelectric active portion is formed for each pressure generating chamber. Furthermore, it is noted here that the piezoelectric element 700 and a vibration plate causing displacements owing to the driving of the piezoelectric element 700 is collectively referred to as a piezoelectric actuator. It is noted that the piezoelectric layer 70 is provided independently for each of the pressure generating chambers 12, and is composed of plural layers of ferroelectric films 71 (71 a - 71 f), as shown in FIG. 40.

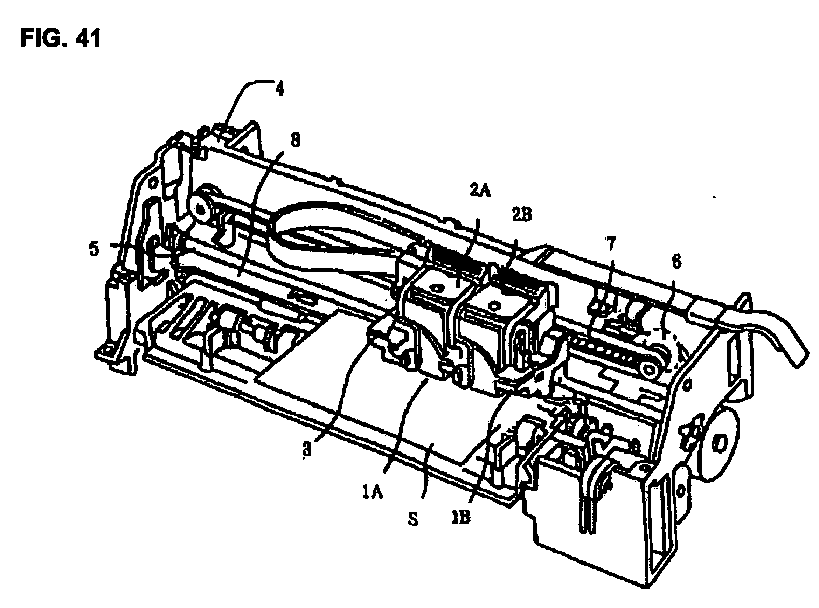

An ink-jet recording head constitutes a part of a recording head unit including an ink flow passage communicating with an ink cartridge and the like, and is mounted on an ink-jet recording apparatus. FIG. 41 is a schematic view showing one example of the ink-jet recording apparatus. As shown in FIG. 41, in recording head units 1 A and 1 B having the ink-jet recording heads, cartridges 2A and 2B constituting ink supplying means are detachably provided. A carriage 3 having these recording head units 1A and 1 B mounted thereon is provided on a carriage shaft 5 attached to an apparatus body 4 so as to be freely movable in the shaft direction. These recording head units 1A and 1 B, for example, are set to eject a black ink composition and a color ink composition, respectively. A driving force of a drive motor 6 is transmitted to the carriage 3 via a plurality of gears (not shown) and a timing belt 7, thereby moving the carriage 3 with the recording head units 1A and 1B mounted thereon along the carriage shaft 5. A platen 8 is provided on the apparatus body 4 along the carriage shaft 5, and a recording sheet S as a recording medium, such as, paper or the like fed by a paper feed roller (not shown) or the like is conveyed onto the platen 8.

Although description has been made for the ink-jet recording head as one example as an ink jet head that ejects ink, the present invention concerns liquid jet heads that use piezoelectric elements and liquid jet apparatus in general. As liquid jet heads, for example, a recording head that is used for image recording apparatuses such as printers, a color material jet head that is used for manufacturing color filters for liquid crystal displays or the like, an electrode material jet head that is used for forming electrodes of organic EL displays, FEDs (face emission displays) and the like, a bio-organic material jet head that is used for manufacturing bio-chips, and the like can be enumerated.

The piezoelectric element in accordance with the present embodiment uses a PZTN film of the embodiment described above as its piezoelectric layer, and thus provides the following effects.

(1) Due to the fact that the covalent bond within the piezoelectric layer improves, the piezoelectric constant can be improved.

(2) Due to the fact that PbO vacancies within the piezoelectric layer can be suppressed, generation of heterogeneous phases at the interface between the piezoelectric layer and the electrode is suppressed, and an electric field can readily be applied, thereby improving the efficiency as a piezoelectric element.

(3) Due to the fact that the leakage current of the piezoelectric layer can be suppressed, the piezoelectric layer can be made thinner.
The liquid jet head and the liquid jet apparatus in accordance with the present embodiment use piezoelectric elements including the piezoelectric layer described above, and thus provide the following effects in particular.

(4) Due to the fact that fatigue deterioration of the piezoelectric layer can be alleviated, a change with the lapse of time in the amount of displacement of the piezoelectric layer can be suppressed, and therefore its reliability can be improved.

**Claims**

1.   A ferroelectric capacitor comprising:

a substrate;

a first electrode (102) formed above the substrate;

a PZT system ferroelectric film (101) formed on the first electrode (102); and

a second electrode (103) formed on the PZT system ferroelectric film (101); wherein

the ferroelectric of the PZT system ferroelectric film (101) is expressed by the general formula of $PbZr_xTi_yNb_z$, wherein $x + y + z = 1$ and $0.05 \leq z \leq 0.3$;

the first electrode (102) does substantially not include any oxygen that diffuses from the PZT system ferroelectric film (101); and

said ferroelectric film (101) has a generally constant distribution of proportion of oxygen atoms in said ferroelectric film (101).

2. The capacitor according to claim 1, wherein $0 \leq x \leq 0.975$.

3. The capacitor according to claim 1, wherein the diffusion length of oxygen in the first electrode (102) from said ferroelectric film (101) is 15 nm or less, as obtained from a profile according to a Rutherford backscattering analysis method and a nuclear reaction analysis method.

4. The capacitor according to claim 1, wherein the diffusion length of oxygen in the first electrode (102) from said ferroelectric film (101) is 30 nm or less, as obtained from a profile according to an Auger electron spectroscopy.

5. The capacitor according to claim 1, wherein the distribution of proportion of oxygen atoms in said first ferroelectric film (101) is 1% or less, when a difference in proportions of oxygen atoms in said ferroelectric film (101) in a film thickness direction thereof is expressed by (a maximum value - a minimum value) / (an average value of the maximum value and the minimum value) and obtained from a profile according to a Rutherford backscattering analysis method and a nuclear reaction analysis method.

6. The capacitor according to claim 1, wherein the distribution of proportion of oxygen atoms in said ferroelectric film (101) is 3% or less, when a difference in proportions of oxygen atoms in said ferroelectric film (101) in a film thickness direction thereof is expressed by (a maximum value - a minimum value) / (an average value of the maximum value and the minimum value) and obtained from a profile according to an Auger electron spectroscopy.

7. The capacitor according to any one of claims 1 through 6, wherein, in said ferroelectric film (101), 95% or more of oxygen contained in said ferroelectric film (101) exists at positions of oxygen of a perovskite structure.

8. The capacitor according to any one of claims 1 through 7, wherein the proportion of Ti in said ferroelectric film (101) is higher than that of Zr.

9. The capacitor according to any one of claims 1 through 8, wherein said ferroelectric film (101) has a crystal structure of at least one of tetragonal and rhombohedral systems.

10. The capacitor according to any one of claim 1 through 9, including 0.5 mol% or more of Si, or Si and Ge.

11. The capacitor according to any one of claim 1 through 10, including 0.5 mol% or more but 5 mol% or less of Si, or Si and Ge.

12. The capacitor according to any one of claims 1 through 11, wherein said ferroelectric film (101) contains at least one of Ta, W, V and Mo that replaces all or a part of the Nb.

13. The capacitor according to any one of claims 1 through 12, wherein the first electrode (102) is formed from a platinum group element or an alloy thereof.

14. A ferroelectric memory using the capacitor as defined in any one of claims 1 through 13.

15. A piezoelectric element using the capacitor as defined in any one of claims 1 through 13.

16. A liquid jet head using the piezoelectric element as defined in claim 15.

17. A printer using the liquid jet head as defined in claim 16.

**Patentansprüche**

1. Ferroelektrischer Kondensator, umfassend:

   ein Substrat;
   eine erste Elektrode (102), die auf dem Substrat gebildet ist;
   einen auf der ersten Elektrode (102) gebildeten ferroelektrischen Film (101) des PZT-Systems; und
   eine zweite Elektrode (103), die auf dem ferroelektrischen Film (101) des PZT-Systems gebildet ist; wobei
   das Ferroelektrikum des ferroelektrischen Films (101) des PZT-Systems durch die allgemeine Formel (PbZr$_x$-Ti$_y$Nb$_z$ ausgedrückt ist, wobei x+y+z = 1 und $0{,}05 \leq z \leq 0{,}3$;
   die erste Elektrode (103) im wesentlichen keinerlei vom ferroelektrischen Film (101) des PZT-Systems diffundierenden Sauerstoff enthält; und
   der ferroelektrische Film (101) eine im wesentlichen konstante Anteilsverteilung von Sauerstoffatomen in dem ferrroelektrischen Film (101) besitzt.

2. Kondensator nach Anspruch 1, bei dem $0 \leq x \leq 0{,}975$.

3. Kondensator nach Anspruch 1, bei dem die Diffusionslänge von Sauerstoff in der ersten Elektrode (102) von dem ferroelektrischen Film (101) 15 nm oder weniger beträgt, ermittelt aus einem Profil gemäß einem Rutherford-Backscattering-Analyseverfahren und einem nuklearen Reaktionsanalyseverfahren.

4. Kondensator nach Anspruch 1, bei dem die Diffusionslänge von Sauerstoff in der ersten Elektrode (102) von dem ferroelektrischen Film (101) 30 nm oder weniger beträgt, ermittelt aus einem Profil gemäß einer Auger-Elektronenspektroskopie.

5. Kondensator nach Anspruch 1, bei dem die Anteilsverteilung von Sauerstoffatomen in dem ferroelektrischen Film (101) 1% oder weniger beträgt, wenn eine Differenz an Sauerstoffatomanteilen in dem ferroelektrischen Film (101) in dessen Filmdickenrichtung ausgedrückt wird durch (einen Maximalwert - einen Minimalwert) / (einen Mittelwert des Maximalwerts und des Minimalwerts) und ermittelt aus einem Profil gemäß einem Rutherford-Backscattering-Analyseverfahren und einem nuklearen Reaktionsanalyseverfahren.

6. Kondensator nach Anspruch 1, bei dem die Anteilsverteilung von Sauerstoffatomen in dem ferroelektrischen Film (101) 3% oder weniger beträgt, wenn eine Differenz an Sauerstoffatomanteilen in dem ferroelektrischen Film (101) in dessen Filmdickenrichtung ausgedrückt wird durch (einen Maximalwert - einen Minimalwert) - (einen Mittelwert des Maximalwerts und des Minimalwerts) und ermittelt aus einem Profil gemäß einer Auger-Elektronenspektroskopie.

7. Kondensator nach einem der Ansprüche 1 bis 6, bei dem, in dem ferroelektrischen Film (101) 95% oder mehr des in dem ferroelektrischen Film (101) enthaltenen Sauerstoffs an Positionen von Sauerstoff einer Perovskitstruktur existieren.

8. Kondensator nach einem der Ansprüche 1 bis 7, bei dem der Anteil von Ti in dem ferroelektrischen Film (101) höher ist als der von Zr.

9. Kondensator nach einem der Ansprüche 1 bis 8, bei dem der ferroelektrische Film (101) eine Kristallstruktur wenigstens eines von Tetragonalsystem und Rhombohedralsystem besitzt.

10. Kondensator nach einem der Ansprüche 1 bis 9 mit 0,5 Mol% oder mehr Si oder Si und Ge.

11. Kondensator nach einem der Ansprüche 1 bis 10 mit 0,5 Mol% oder mehr aber 5 Mol% oder weniger Si oder Si und Ge.

12. Kondensator nach einem der Ansprüche 1 bis 11, bei dem der ferroelektrische Film (101) wenigstens eines von Ta, W, V und Mo als Ersatz für alles oder einen Teil des Nb enthält.

13. Kondensator nach einem der Ansprüche 1 bis 12, bei dem die erste Elektrode (102) aus einem Element der Platingruppe oder einer Legierung davon gebildet ist.

14. Ferroelektrischer Speicher, der den Kondensator nach einem der Ansprüche 1 bis 13 verwendet.

**15.** Piezoelektrisches Element, das den Kondensator nach einen der Ansprüche 1 bis 13 verwendet.

**16.** Flüssigkeitsstrahlkopf, der das piezoelektrische Element von Anspruch 15 verwendet.

**17.** Drucker, der den Flüssigkeitsstrahlkopf nach Anspruch 16 verwendet.

**Revendications**

**1.** Condensateur ferroélectrique comprenant :

un substrat ;
une première électrode (102) formée au dessus du substrat ;
un film (101) ferroélectrique en système PZT formé sur la première électrode (102) ; et
une deuxième électrode (103) formée sur le film (101) ferroélectrique en système PZT ; dans lequel
le ferroélectrique du film (101) ferroélectrique en système PZT est exprimé par la formule générale $PbZr_xTi_yNb_z$
dans laquelle $x + y + z = 1$ et $0{,}05 \le z \le$ à $0{,}3$ ;
la première électrode (102) n'inclut pas sensiblement d'oxygène qui diffuse à partir du film (101) ferroélectrique
en système PZT ; et
le film (101) ferroélectrique a une répartition sensiblement constante de la proportion d'atomes d'oxygène dans
le film (101) ferroélectrique.

**2.** Condensateur suivant la revendication 1, dans lequel $0 \le x \le 0{,}975$.

**3.** Condensateur suivant la revendication 1, dans lequel la longueur de diffusion de l'oxygène dans la première électrode
(102) à partir du film (101) ferroélectrique est inférieure ou égale à 15 nm, telle qu'obtenue par un profil suivant une
méthode d'analyse de rétrodiffusion de Rutherford et suivant une méthode d'analyse de réaction nucléaire.

**4.** Condensateur suivant la revendication 1, dans lequel la longueur de diffusion de l'oxygène dans la première électrode
(102) à partir du film (101) ferroélectrique est inférieure ou égale à 30 nm, telle qu'obtenue par un profil suivant une
spectroscopie d'électron Auger.

**5.** Condensateur suivant la revendication 1, dans lequel la répartition de la proportion d'atomes d'oxygène dans le
premier film (101) ferroélectrique est inférieure ou égale à 1 %, lorsqu'une différence des proportions d'atomes
d'oxygène dans le film (101) ferroélectrique dans la direction d'épaisseur de ce film est exprimée par (une valeur
maximum - une valeur minimum) / (une valeur moyenne de la valeur maximum et de la valeur minimum) et est
obtenue à partir d'un profil suivant une méthode d'analyse de rétrodiffusion de Rutherford et suivant une méthode
d'analyse de réaction nucléaire.

**6.** Condensateur suivant la revendication 1, dans lequel la répartition de la proportion des atomes d'oxygène dans le
film (101) ferroélectrique est inférieure ou égale à 3 %, lorsqu'une différence des proportions d'atomes d'oxygène
dans le film (101) ferroélectrique dans la direction d'épaisseur de ce film est exprimée par (une valeur maximum -
une valeur minimum) / (une valeur moyenne de la valeur maximum et de la valeur minimum) et est obtenue à partir
d'un profil suivant une spectroscopie d'électron Auger.

**7.** Condensateur suivant l'une quelconque des revendications 1 à 6, dans lequel, dans le film (101) ferroélectrique,
95 % ou plus de 95 % de l'oxygène contenu dans le film (101) ferroélectrique existe en des positions de l'oxygène
d'une structure perovskite.

**8.** Condensateur suivant l'une quelconque des revendications 1 à 7, dans lequel la proportion de Ti dans le film (101)
ferroélectrique est plus grande que celle de Zr.

**9.** Condensateur suivant l'une quelconque des revendications 1 à 8, dans lequel le film (101) ferroélectrique a une
structure cristalline composée d'au moins un des systèmes quadratique et rhombohédrique.

**10.** Condensateur suivant l'une quelconque des revendications 1 à 9, comprenant 0,5 % en mole ou plus de 0,5 % en
mole de Si ou de Si et de Ge.

**11.** Condensateur suivant l'une quelconque des revendications 1 à 10, comprenant 0,5 % en mole ou plus de 0,5 % en mole, mais 5 % en mole ou moins de 5 % en mole de Si ou de Si et de Ge.

**12.** Condensateur suivant l'une quelconque des revendications 1 à 11, dans lequel le film (101) ferroélectrique contient au moins l'un de Ta, W, V et Mo qui remplace tout ou partie du Nb.

**13.** Condensateur suivant l'une quelconque des revendications 1 à 12, dans lequel la première électrode (102) est en un élément du groupe du platine ou en l'un de ses alliages.

**14.** Mémoire ferroélectrique utilisant le condensateur tel que défini dans l'une quelconque des revendications 1 à 13.

**15.** Elément piézoélectrique utilisant le condensateur tel que défini suivant l'une quelconque des revendications 1 à 13.

**16.** Tête à jet de liquide utilisant l'élément piézoélectrique tel que défini à la revendication 15.

**17.** Imprimante utilisant la tête à jet de liquide tel que défini à la revendication 16.

**FIG. 1**

100

101

103

102

FIG. 2

ST10 — LOWER ELECTRODE: Pt FILM FORMATION AT ROOM TEMPERATURE

ST11 — Sol-Gel 10w%(PZ×1＋PT×4)×1 ⇒ 500rpm,10sec＋50rpm,10sec

ST12 — N2 FLOW

ST13 — 150°C～180°C,2min＋300°C～350°C,5min on Hot-plate

ST14 — CRYSTALLIZATION ANNEAL : RTA850°C,10min

ST15 — UPPER ELECTRODE Pt FORMATION

ST16 — POST ANNEAL : RTA700°C,10min

FIG. 3

## FIG. 4 (A)

**NONE**

## FIG. 4 (B)

0.5%

## FIG. 4 (C)

1%

FIG. 5 (A)

FIG. 5 (B)

FIG. 5 (C)

## FIG. 6 (A)

120nm

## FIG. 6 (B)

150nm

## FIG. 6 (C)

200nm

FIG. 7 (A)

FIG. 7 (B)

FIG. 7 (C)

120nm

150nm

200nm

# FIG. 8 (A)    # FIG. 8 (B)    # FIG. 8 (C)

120nm

150nm

200nm

EP 1 589 566 B1

## FIG. 9 (A)  FIG. 9 (B)  FIG. 9 (C)

120nm

150nm

200nm

EP 1 589 566 B1

FIG. 10 (A)

FIG. 10 (B)

EP 1 589 566 B1

FIG. 11 (B)

FIG. 11 (A)

FIG. 12

## FIG. 13

## FIG. 14
## ( PRIOR ART)

# FIG. 15
# (PRIOR ART)

## FIG. 16
## (PRIOR ART)

## FIG. 17 (A)

Nb=0 [mol%]

## FIG. 17 (B)

Nb=5 [mol%]

EP 1 589 566 B1

## FIG. 18 (A)

Nb=10 [mol%]

## FIG. 18 (B)

Nb=20 [mol%]

EP 1 589 566 B1

FIG. 19 (B)

FIG. 19 (A)

## FIG. 20

## FIG. 21

**FIG. 22**

WO₃

**FIG. 23 (A)**

**FIG. 23 (B)**

**FIG. 23 (C)**

## FIG. 24 (A)

| | AMOUNT OF Nb ADDED (mol%) | | | | |
|---|---|---|---|---|---|
| | 0 | 5 | 10 | 20 | 30 |
| a | 4.04 | 4.04 | 4.01 | 4.00 | 4.00 |
| c | 4.11 | 4.11 | 4.10 | 4.05 | 4.03 |
| V(abc) | 67.0818 | 67.0818 | 65.9284 | 64.8000 | 64.4800 |
| V/V₀ | 100.0 | 100.0 | 98.3 | 96.6 | 96.1 |

## FIG. 24 (B)

EP 1 589 566 B1

**FIG. 25**

**FIG. 26**

EP 1 589 566 B1

ST20
```
LOWER ELECTRODE: Pt FILM FORMATION AT ROOM TEMPERATURE
```

ST21
```
Sol-Gel 10w%(PZ × 1 + PT × 4) × 1  ⇒  500rpm,10sec + 50rpm,10sec
```

ST22
```
150°C ~ 180°C,2min + 300°C ~ 350°C,5min on Hot-plate
```

ST23
```
CRYSTALLIZATION ANNEAL  : RTA650°C/10min
```

ST24
```
Pt UPPER ELECTRODE Pt FORMATION
```

ST25
```
POST-ANNEAL : RTA700°C/10min
```

**FIG. 27 (A)**  **FIG. 27 (B)**  **FIG. 27 (C)**  **FIG. 27 (D)**  **FIG. 27 (E)**

Stoichiometry    5% excess    10% excess    15% excess    20% excess

**FIG. 28 (A)**   **FIG. 28 (B)**   **FIG. 28 (C)**   **FIG. 28 (D)**   **FIG. 28 (E)**

Stoichiometry   5% excess   10% excess   15% excess   20% excess

EP 1 589 566 B1

FIG. 29 (B)

FIG. 29 (A)

# FIG. 30
# (PRIOR ART)

FIG. 31 (B)

FIG. 31 (A)

# FIG. 32 (A)

# FIG. 32 (B)

EP 1 589 566 B1

# FIG. 33

EP 1 589 566 B1

## FIG. 34 (A)

## FIG. 34 (B)

# FIG. 35

| ELEMENT | ATOMIC WEIGHT | VALENCE | | ATOMIC RADIUS | BONDING ENERGY (M-O) | IONIZATION ENERGY |
|---|---|---|---|---|---|---|
| | | IONIC RADIUS (Å) | | (Å) | (kcal/mol) | (eV) |
| Pb | 207.2 | +2(1.08),+4(0.78) | | 1.33 | 38.8 | 7.416 |
| Zr | 91.224 | +4(0.72) | | 1.6 | | 6.84 |
| Ti | 47.88 | +2(0.86),+3,+4(0.61) | | 1.47 | 73 | 6.82 |
| Nb | 92.906 | +3,+4,+5(0.64) | | 1.47 | | 6.88 |
| O | 54.36 | -1,-2(1.4) | | | | 13.618 |

EP 1 589 566 B1

## FIG. 36 (A)

**BROWNMILLERRITE STRUCTURE (ABO2.5)**

## FIG. 36 (B)

**CATION DEFECT**

THIS CONTIBUTES TO INCREASE IN LEAKAGE CURRENT

THIS DOES NOT CONTIBUTE TO INCREASE IN LEAKAGE CURRENT

## FIG. 36 (C)

**ANION DEFECT**

# FIG. 37

**POLARIZATION**

**LEFT AT Tc OR LOWER**

Pa ACTS IN DIRECTION THAT CANCELS PF

**FIG. 38**

## FIG. 39 (A)

## FIG. 39 (B)

# FIG. 40

FIG. 41

# FIG. 42 (A)

# FIG. 42 (B)

## FIG. 43

## FIG. 44 (A)

### PZTN

## FIG. 44 (B)

### PZN(20/80)

## FIG. 45 (A)

PZTN

## FIG. 45 (B)

PZT (20/80)

## FIG. 46

DIFFUSION LENGTH = FILM THICKNESS OF Pt X AREA 1 / (AREA 1 + AREA 2)

## FIG. 47

DIFFUSION LENGTH = FILM THICKNESS OF Pt X DEPTH 1 / DEPTH 2

# FIG. 48 (A)

**RAMAN SPECTRUM OF PZTN (36/44/20)**

# FIG. 48 (B)

**RAMAN SPECTRUM OF PZTN (20/60/20)**

**FIG. 49 (A)**　　PZTN(36/46/20)

PZT(56/44)

**FIG. 49 (B)**

## FIG. 50 (A)

ESCA DEPTH ANALYSIS OF PZTN (36/44/20)

## FIG. 50 (B)

ESCA DEPTH ANALYSIS OF PZT (56/44)

## FIG. 51

PIEZZOELECTRIC
CHARACTERISTICS $\mathrm{AFM}\text{-}d_{33}$

## FIG. 52 (A)

IN-PLANE UNIFORMITY (CENTERAL
AREA) OF WAFER WITH PZTN
(36/44/20) ORIENTATION

# FIG. 52 (B)

**IN-PLANE UNIFORMITY
(PERIPHERAL AREA) OF WAFER
WITH PZTN (36/44/20)
ORIENTATION**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 9116107 A

**Non-patent literature cited in the description**

- **H. MIYAZAWA ; E. NATORI ; S. MIYASHITA.** *Jpn. J. Appl. Phys.,* 2000, vol. 39, 5679
- *J. Am. Ceram. Soc,* 2001, vol. 84, 902
- *Phys. Rev. Let,* 1999, vol. 83, 1347
- *J. Am, Ceram. Soc,* 2001, vol. 84, 902
- *Phys. Rev. Let,* 1999, vol. 83, 1347